# EUROPEAN PATENT APPLICATION

(11) **EP 4 637 310 A1**
(43) Date of publication of application: **22.10.2025**
(21) Application number: 25169429.5
(22) Date of filing: 09.04.2025
(51) Int. Cl.: H10K 59/131, H10K 59/00, H10K 59/82, H10K 59/90, G02B 27/01

(54) **DISPLAY DEVICE AND HEAD MOUNTED DISPLAY DEVICE**

(30) Priority: 15.04.2024 KR 20240050064
(71) Applicant: Samsung Display Co., Ltd., Yongin-si, Gyeonggi-do 17113 (KR)
(72) Inventor: KANG, Sin Chul, Yongin-si (KR); SONG, Dae Ho, Yongin-si (KR)
(74) Representative: Marks & Clerk LLP

(57) **Abstract**

A display device and a head mounted display device are provided. A display device includes a first single crystal semiconductor substrate on which a plurality of first transistors is formed, a second single crystal semiconductor substrate on the first single crystal semiconductor substrate, and on which a plurality of second transistors is formed, and a connection wiring layer between the first single crystal semiconductor substrate and the second single crystal semiconductor substrate. The second single crystal semiconductor substrate includes a display area where a plurality of light emitting elements electrically connected to the plurality of second transistors is located, and a non-display area around the display area. A plurality of first through holes located in the display area of the second single crystal semiconductor substrate and in which a first conductive via connected to each of the plurality of first transistors and the plurality of second transistors is located.

## Description

### BACKGROUND

### 1. Field

One or more embodiments of the present disclosure relate to a display device and a head mounted display device.

### 2. Description of the Related Art

A head mounted display device (HMD) is an image display device that is worn on a user's head in the form of glasses or helmets to form a focus at a close distance in front of the user's eyes. The head mounted display device may implement virtual reality (VR) and/or augmented reality (AR).

The head mounted display device magnifies an image displayed on a small display device by using a plurality of lenses, and displays the magnified image. Therefore, the display device applied to the head mounted display device needs to provide high-resolution images, for example, images with a resolution of 3000 PPI (Pixels Per Inch) or higher. To this end, an organic light emitting diode on silicon (OLEDoS), which is a high-resolution small organic light emitting display device, is used as the display device applied to the head mounted display device. The OLEDoS is an image display device in which an organic light emitting diode (OLED) is disposed on a semiconductor wafer substrate on which a complementary metal oxide semiconductor (CMOS) is disposed.

### SUMMARY

Aspects and features of embodiments of the present disclosure provide a micro-display device including a plurality of different single crystal semiconductor substrates, and a head mounted display device including the same.

Aspects of the present disclosure also provide a micro-display device implemented by efficient layout design of wires disposed on two different semiconductor substrates.

However, embodiments of the present disclosure are not limited to those set forth herein. The above and other embodiments of the present disclosure will become more apparent to one of ordinary skill in the art to which the present disclosure pertains by referencing the detailed description of the present disclosure given below.

According to one or more embodiments of the present disclosure, there is provided a display device including a first single crystal semiconductor substrate on which a plurality of first transistors is formed, a second single crystal semiconductor substrate on the first single crystal semiconductor substrate, and on which a plurality of second transistors is formed, and a connection wiring layer between the first single crystal semiconductor substrate and the second single crystal semiconductor substrate, the second single crystal semiconductor substrate includes a display area where a plurality of light emitting elements electrically connected to the plurality of second transistors is located, and a non-display area around the display area, and a plurality of first through holes located in the display area of the second single crystal semiconductor substrate and in which a first conductive via connected to each of the plurality of first transistors and the plurality of second transistors is located.

The display device may further include a first driving voltage line in a common electrode contact area of the non-display area on at least one side of the display area, and a second driving voltage line in the display area. A second transistor from among the plurality of second transistors may be connected to the second driving voltage line. A light emitting element from among the plurality of light emitting elements may be connected to the first driving voltage line.

An area of the first single crystal semiconductor substrate in a plan view may be smaller than an area of the second single crystal semiconductor substrate in a plan view.

The connection wiring layer may include a plurality of first connection lines connected to the first conductive via. At least a portion of the plurality of first connection lines may not overlap the first single crystal semiconductor substrate.

The second single crystal semiconductor substrate may include a pad area on one side of the display area, and a plurality of second through holes between the pad area and the display area.

The display device may further include a first scan driver and a data driver on the first single crystal semiconductor substrate and including the plurality of first transistors.

The display device may further include first scan lines on the first single crystal semiconductor substrate and connected to a first transistor from among the plurality of first transistors and the first scan driver, and data lines on the first single crystal semiconductor substrate and connected to the first transistor and the data driver.

The second single crystal semiconductor substrate may include a plurality of second scan lines and a plurality of emission control lines electrically connected to some of the plurality of second transistors.

The second single crystal semiconductor substrate may include a second scan driver in the non-display area and connected to the plurality of second scan lines, and an emission driver in the non-display area and connected to an emission control line from among the plurality of emission control lines.

The second single crystal semiconductor substrate may include a plurality of third through holes in which a conductive via connected to a second scan line from among the plurality of second scan lines is located, and a plurality of fourth through holes in which a conductive via connected to an emission control line from among the plurality of emission control lines is located. The first single crystal semiconductor substrate may include a second scan driver connected to the second scan line through the conductive via in the third through hole, and an emission driver connected to the emission control line through the conductive via in the fourth through hole.

Each of the plurality of third through holes and the plurality of fourth through holes may not overlap the first single crystal semiconductor substrate.

A number of the plurality of third through holes may be the same as a number of the plurality of fourth through holes.

The connection wiring layer may include connection lines connected to a plurality of conductive vias in the plurality of third through holes and the plurality of fourth through holes. Each of the connection lines may have a portion that does not overlap the first single crystal semiconductor substrate.

The number of the first through holes may be equal to the number of the light emitting elements in the display area.

A minimum line width of a first transistor from among the plurality of first transistors may be smaller than a minimum line width of a second transistor from among the plurality of second transistors.

According to one or more embodiments of the present disclosure, there is provided a display device including a first single crystal semiconductor substrate on which a plurality of first transistors is formed and a plurality of first scan lines and a plurality of data lines are located, a second single crystal semiconductor substrate on the first single crystal semiconductor substrate, on which a plurality of second transistors is formed, and at least one driving voltage line connected to some of the plurality of second transistors is located, a display element layer on the second single crystal semiconductor substrate, and including a plurality of light emitting elements, and a connection wiring layer located between the display element layer and the first single crystal semiconductor substrate, and the plurality of light emitting elements is electrically connected to the at least one driving voltage line, the plurality of first transistors, and the plurality of second transistors, and the connection wiring layer includes a first connection line connected to a first conductive via in a first through hole penetrating the second single crystal semiconductor substrate, and the first conductive via is electrically connected to the plurality of first transistors and the plurality of second transistors.

The at least one driving voltage line may include a first driving voltage line connected to one electrode of a light emitting element from among the plurality of light emitting elements, and a second driving voltage line electrically connected to a second transistor from among the plurality of second transistors.

The display device may further include a plurality of second scan lines and a plurality of emission control lines on the second single crystal semiconductor substrate.

An area of the first single crystal semiconductor substrate in a plan view may be smaller than an area of the second single crystal semiconductor substrate in a plan view.

According to one or more embodiments of the present disclosure, there is provided a head mounted display device including a frame mounted on a user's body and corresponding to left and right eyes, a plurality of display devices in the frame, and a lens on each of the plurality of display devices. The display device includes a first single crystal semiconductor substrate on which a plurality of first transistors is formed, a second single crystal semiconductor substrate on the first single crystal semiconductor substrate, and on which a plurality of second transistors is formed, and a connection wiring layer between the first single crystal semiconductor substrate and the second single crystal semiconductor substrate, wherein the second single crystal semiconductor substrate includes a display area where a plurality of light emitting elements electrically connected to the second transistors is located, and a non-display area around the display area, wherein a plurality of first through holes in the display area of the second single crystal semiconductor substrate and in which a first conductive via connected to each of the plurality of first transistors and the plurality of second transistors is located.

A display device according to one or more embodiments may include two different single crystal semiconductor substrates, and a pixel circuit for light emission of a light emitting element may be dividedly on two different single crystal semiconductor substrates. In the display device, wires connected to the divided pixel circuits may be respectively on two different single crystal semiconductor substrates. Further, in the display device, by dividedly disposing the wires on two single crystal semiconductor substrates, it is possible to design an efficient current path and prevent a voltage drop depending on a pixel position.

At least some of the above and other features of the invention are set out in the claims.

### BRIEF DESCRIPTION OF THE DRAWINGS

The above and other embodiments and features of the present disclosure will become more apparent by describing embodiments thereof with reference to the attached drawings, in which:
FIG. 1 is an exploded perspective view of a display device according to one or more embodiments;
FIG. 2 is a plan view illustrating an example of the driving unit shown in FIG. 1;
FIG. 3 is a plan view illustrating an example of the display unit shown in FIG. 1;
FIG. 4 is a block diagram illustrating a display device according to one or more embodiments;
FIG. 5 is an equivalent circuit diagram of one pixel according to one or more embodiments;
FIG. 6 is a diagram showing wires disposed in a driving unit of a display device according to one or more embodiments;
FIG. 7 is a diagram showing connections between a pixel circuit and wires disposed in a display unit of a display device according to one or more embodiments;
FIG. 8 is a schematic cross-sectional view of a display device according to one or more embodiments;
FIG. 9 is a schematic diagram showing a rear surface of a display device according to one or more embodiments;
FIG. 10 is a schematic cross-sectional view of a driving unit according to one or more embodiments;
FIG. 11 is a plan view showing a pixel defining film, and first electrodes and emission areas of a plurality of sub-pixels disposed in a display area of a display unit according to one or more embodiments;
FIG. 12 is a plan view showing a pixel defining film, and first electrodes and emission areas of a plurality of sub-pixels disposed in a display area of a display unit according to one or more embodiments;
FIG. 13 is a cross-sectional view illustrating a portion of a display unit according to one or more embodiments;
FIG. 14 is a block diagram showing an example of a display device according to one or more embodiments;
FIG. 15 is an equivalent circuit diagram of one pixel of the display device of FIG. 14;
FIG. 16 is a plan view showing an example of a driving unit of the display device of FIGS. 14 and 15;
FIG. 17 is a plan view showing an example of a display unit of the display device of FIGS. 14 and 15;
FIG. 18 is a plan view showing the disposition of a plurality of wires disposed in the display unit of FIG. 17;
FIG. 19 is a schematic diagram showing a rear surface of the display device of FIGS. 16 and 17;
FIG. 20 is a plan view showing an example of a driving unit of a display device according to one or more embodiments;
FIG. 21 is a plan view illustrating an example of a display unit of the display device of FIG. 20;
FIG. 22 is a schematic cross-sectional view of the display device of FIGS. 20 and 21;
FIG. 23 is a schematic diagram showing a rear surface of the display device of FIGS. 20 and 21;
FIG. 24 is a cross-sectional view showing a portion of the display unit of the display device of FIGS. 20 and 21;
FIG. 25 is a perspective view illustrating a head mounted display device according to one or more embodiments;
FIG. 26 is an exploded perspective view showing an example of the head mounted display device of FIG. 25; and
FIG. 27 is a perspective view illustrating a head mounted display device according to one or more embodiments.

### DETAILED DESCRIPTION

Aspects and features of embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may be embodied in various different forms, and should not be construed as being limited to only the illustrated embodiments herein. Rather, these embodiments are provided as examples so that the present disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure might not be described.

Unless otherwise noted, like reference numerals, characters, or combinations thereof denote like elements throughout the attached drawings and the written description, and thus, descriptions thereof will not be repeated. Further, parts not related to the description of one or more embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the present disclosure. Thus, embodiments disclosed herein should not be construed as limited to the particular illustrated shapes of regions, but are to include deviations in shapes that result from, for instance, manufacturing.

For example, an implanted region illustrated as a rectangle may have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, in this specification, the phrase "on a plane," or "in a plan view," means viewing a target portion from the top, and the phrase "on a cross-section" means viewing a cross-section formed by vertically cutting a target portion from the side.

It will be understood that when an element, layer, region, or component is referred to as being "formed on," "on," "connected to," or "coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled" refers to one component directly connecting or coupling another component without an intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of the present disclosure, expressions such as "at least one of," "one of," and "selected from," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, XZ, YZ, and ZZ, or any variation thereof. Similarly, the expression such as "at least one of A and/or B" may include A, B, or A and B. As used herein, the term "and/or" includes any and all combinations of one or more of the associated listed items. For example, the expression such as "A and/or B" may include A, B, or A and B. Further, the use of "may" when describing embodiments of the present disclosure refers to "one or more embodiments of the present disclosure".

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

When one or more embodiments may be implemented differently, a specific process order may be performed differently from the described order. For example, two consecutively described processes may be performed substantially at the same time or performed in an order opposite to the described order.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, for example, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirement of basis in the application as filed.

The electronic or electric devices and/or any other relevant devices or components according to one or more embodiments of the present disclosure described herein may be implemented utilizing any suitable hardware, firmware (e.g., an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning for example consistent with their meaning in the context of the relevant art and/or the present specification, and should not be interpreted in an idealized or overly formal sense, unless expressly so defined herein.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

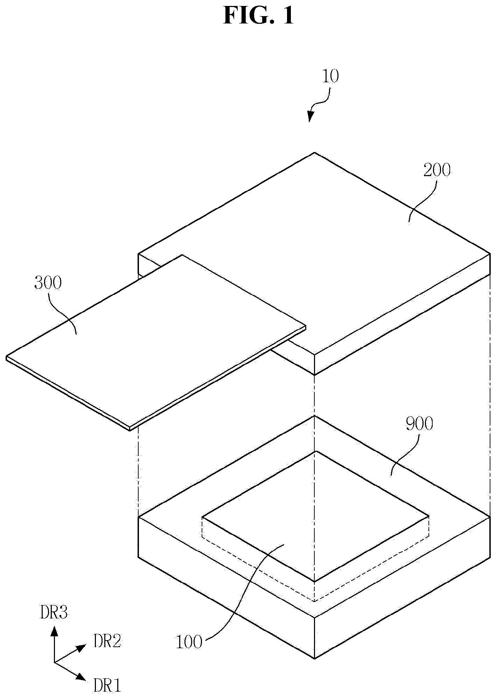

FIG. 1 is an exploded perspective view of a display device according to one or more embodiments.

Referring to FIG. 1, a display device 10 according to one or more embodiments is a device for displaying a moving image and/or a still image. The display device 10 according to one or more embodiments may be applied to portable electronic devices such as a mobile phone, a smartphone, a tablet personal computer, a mobile communication terminal, an electronic organizer, an electronic book, a portable multimedia player (PMP), a navigation system, an ultra-mobile PC (UMPC), and/or the like. For example, the display device 10 may be applied as a display unit of a television, a laptop, a monitor, a billboard, or an Internet-of-Things (IoT) device. Alternatively, the display device 10 may be applied to a smart watch, a watch phone, a head mounted display device (HMD) for implementing virtual reality and augmented reality, and/or the like.

The display device 10 according to one or more embodiments may include a driving unit 100, a display unit 200, and a circuit board 300. The display device 10 may further include a passivation layer 900 disposed around the driving unit 100.

The driving unit 100 may have a planar shape similar to a quadrilateral shape. For example, the driving unit 100 may have a planar shape similar to a rectangular shape, having one side extending along a first direction DR1 and the other side extending along a second direction DR2 crossing the first direction DR1. The one side of the driving unit 100 in the first direction DR1 and the other side thereof in the second direction DR2 may have different lengths. In the driving unit 100, a corner where one side in the first direction DR1 and the other side in the second direction DR2 meet may be right-angled or rounded with a suitable curvature (e.g., a predetermined curvature). The planar shape of the driving unit 100 is not limited to a rectangular shape, and may be a shape similar to another polygonal shape, a circular shape, and/or an elliptical shape.

The display unit 200 may be disposed on the driving unit 100. In the display device 10, the driving unit 100 and the display unit 200 may be bonded to each other. Unlike the driving unit 100, the display unit 200 may have a shape similar to a square. For example, the driving unit 100 and the display unit 200 may have a planar shape similar to a square in which one side in the first direction DR1 and the other side in the second direction DR2 crossing the first direction DR1 have the same length. The planar shape of the display unit 200 is not limited to a rectangular shape, and may be a shape similar to another polygonal shape, a circular shape, and/or an elliptical shape. The planar shape of the display device 10 may conform to the planar shape of the display unit 200, but is not limited thereto.

According to one or more embodiments, in the display device 10, the area of the display unit 200 in a plan view may be larger than the area of the driving unit 100 in a plan view. The display device 10 may include the driving unit 100 and the display unit 200 having different substrates, and they may have different areas. Elements formed in the driving unit 100 and elements formed in the display unit 200 may be different, and these elements may be formed individually on different substrates. The display device 10 may be fabricated by forming multiple elements with different sizes, line widths, and fabrication processes on different substrates and then bonding them. The product performance and fabrication yield can be improved in the display device 10.

The circuit board 300 may be electrically connected to a plurality of pads in a pad area of the display unit 200 by using a conductive adhesive member such as an anisotropic conductive film. The circuit board 300 may be a flexible printed circuit board (FPCB) with a flexible material, or a flexible film. Although the circuit board 300 is illustrated in FIG. 1 as being unfolded, the circuit board 300 may be bent. In this case, one end of the circuit board 300 may be disposed on the bottom surface of the driving unit 100. The other end of the circuit board 300 may be connected to the plurality of pads in the pad area of the display unit 200 by using the conductive adhesive member. In one or more embodiments, the circuit board 300 may be attached to the bottom surface of the driving unit 100.

The passivation layer 900 may be disposed on the bottom surface of the display unit 200 while surrounding the driving unit 100. The passivation layer 900 may reduce a level difference caused by the difference in area between the driving unit 100 and the display unit 200, and may also protect the driving unit 100 and the display unit 200.

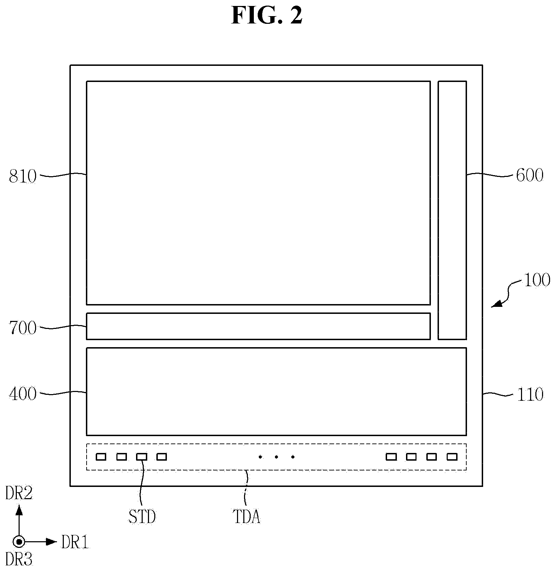

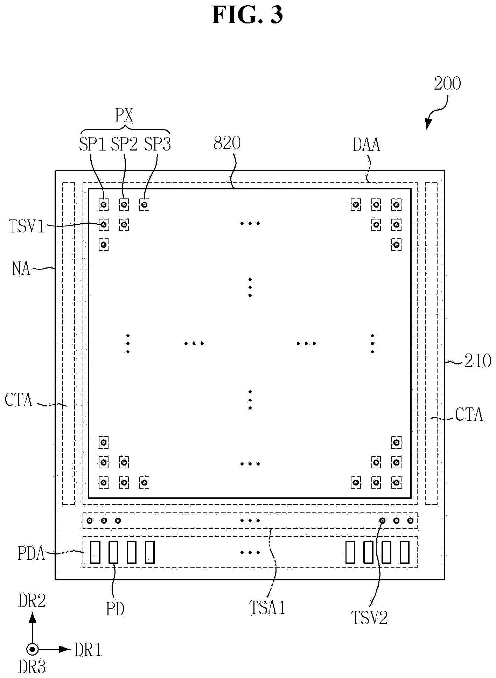

FIG. 2 is a plan view illustrating an example of the driving unit shown in FIG. 1. FIG. 3 is a plan view illustrating an example of the display unit shown in FIG. 1.

Referring to FIGS. 2 and 3, the driving unit 100 of the display device 10 may include driving circuit elements of the display device 10. The driving unit 100 may include a first single crystal semiconductor substrate 110, and a driving circuit 400, a gate driver 600, a data driver 700, and a first pixel circuit 810 formed on the first single crystal semiconductor substrate 110. The gate driver 600 may include a scan driver.

The first single crystal semiconductor substrate 110 may be a silicon substrate, a germanium substrate, and/or a silicon-germanium substrate. A plurality of first transistors may be formed on the first single crystal semiconductor substrate 110. The plurality of first transistors may be electrically connected to each other and constitute the driving circuit 400, the gate driver 600, the data driver 700, and the first pixel circuit 810. The first transistors may be formed through a semiconductor process. For example, the plurality of transistors may be formed as complementary metal oxide semiconductor (CMOS) transistors.

The drawing illustrates that the first pixel circuit 810 is disposed on the upper side of the driving unit 100, the data driver 700, the driving circuit 400, and a signal terminal area TDA are disposed below the first pixel circuit 810, and the gate driver 600 is disposed on the right side of the first pixel circuit 810, which is one side of the first direction DR1. However, the present disclosure is not limited thereto. In the driving unit 100, the positions of the driving circuit 400, the gate driver 600, and the data driver 700 may be varied depending on the design structure of a plurality of circuit elements formed on the first single crystal semiconductor substrate 110.

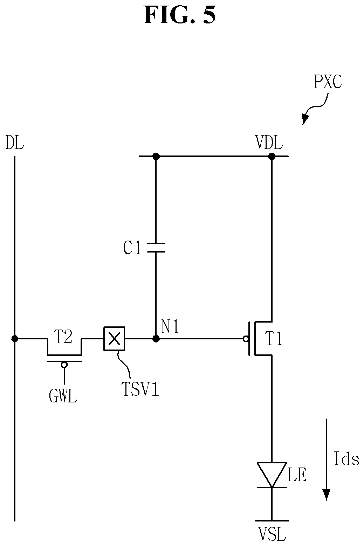

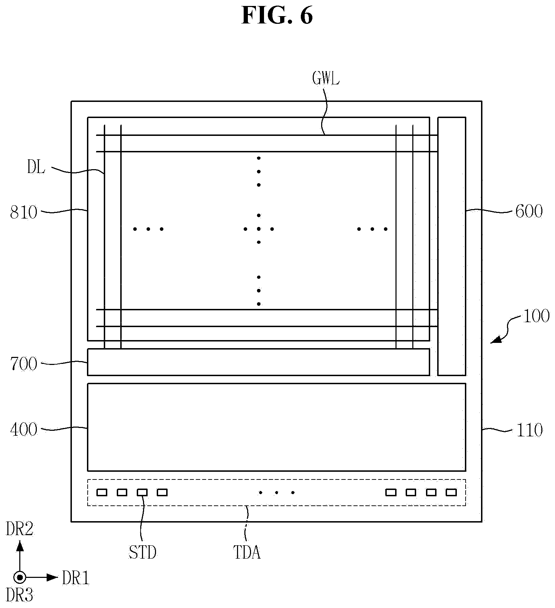

The first pixel circuit 810 may include a plurality of first transistors, and a plurality of scan lines GWL (see FIG. 6) and data lines DL (see FIG. 6) electrically connected to the first transistor. The first transistors may be electrically connected to the first scan lines GWL and the data lines DL, and may constitute a pixel circuit PXC (pixel circuit of FIG. 5) of each of sub-pixels SP1, SP2, and SP3.

In the signal terminal area TDA, a plurality of signal terminals STD arranged along the first direction DR1 may be disposed. The plurality of signal terminals STD may be electrically connected to the display unit 200 and may be electrically connected to the circuit board 300 via them. The signal terminals STD may transmit an electrical signal applied from the circuit board 300 to the driving circuit 400, the gate driver 600, and the data driver 700.

The display unit 200 may include a second single crystal semiconductor substrate 210, and a plurality of pixels PX and a second pixel circuit 820 formed on the second single crystal semiconductor substrate 210. The display unit 200 may include a display area DAA where the plurality of pixels PX are disposed and a non-display area NA around (e.g., surrounding) the display area DAA. The display unit 200 may include a first through hole area TSA1, a pad area PDA, and a common electrode contact area CTA that are disposed in the non-display area NA. The common electrode contact area CTA may be disposed in the non-display area NA on the left side and the right side of the display area DAA, which are both sides in the first direction DR1.

The second single crystal semiconductor substrate 210 may be a silicon substrate, a germanium substrate, and/or a silicon-germanium substrate. A plurality of second transistors may be formed on the second single crystal semiconductor substrate 210, and the plurality of second transistors may be electrically connected to each other to form the pixel circuit for light emission of the plurality of pixels PX. The second transistors may be formed through a semiconductor process. For example, the plurality of transistors may be formed as complementary metal oxide semiconductor (CMOS) transistors.

The plurality of pixels PX including light emitting elements may be disposed in the display area DAA. Each of the plurality of pixels PX may include three sub-pixels, for example, a first sub-pixel SP1, a second sub-pixel SP2, and a third sub-pixel SP3. Three sub-pixels SP1, SP2, and SP3 may constitute one pixel PX to display a color. However, the present disclosure is not limited thereto, and one pixel PX may include three or more sub-pixels. The plurality of sub-pixels SP may be arranged in a matrix form along the first direction DR1 and the second direction DR2. For example, the plurality of sub-pixels SP may be arranged along rows and columns of a matrix along the first direction DR1 and the second direction DR2. Each of the plurality of sub-pixels SP1, SP2, and SP3 may be electrically connected to the pixel circuit PXC (see FIG. 5) composed of the plurality of second transistors formed on the second single crystal semiconductor substrate 210. Each of the sub-pixels SP1, SP2, and SP3 may include light emitting elements, and the light emitting elements may emit light according to an electrical signal applied from a pixel circuit disposed in the display area DAA.

Some of the sub-pixels SP1, SP2, and SP3 disposed in the display area DAA of the display unit 200 may overlap the driving unit 100 in a thickness direction of the display device 10 (e.g., a third direction DR3), and others may not overlap the driving unit 100. The driving unit 100 has a smaller area than that of the display unit 200 and may be disposed adjacent to one side of the display unit 200. Accordingly, only some of the sub-pixels SP1, SP2, and SP3 may overlap the driving unit 100 in the thickness direction (e.g., the third direction DR3).

The second pixel circuit 820 may include a plurality of second transistors formed on the second single crystal semiconductor substrate 210. The plurality of second transistors may be formed through a semiconductor process. For example, the plurality of second transistors may be formed as CMOS transistors. The second pixel circuit 820 may include a plurality of second transistors and driving voltage lines VDL and VSL (see FIG. 5) electrically connected to the second transistor. The second transistor may be electrically connected to the first transistor of the driving unit 100, the driving voltage lines VDL and VSL of the display unit 200, and the light emitting element, and may constitute the pixel circuit PXC (pixel circuit of FIG. 5) to which each of the sub-pixels SP1, SP2, and SP3 is connected.

According to one or more embodiments, the display unit 200 of the display device 10 may include a plurality of first through holes TSV1 that overlap the display area DAA. The first through holes TSV1 may be formed to penetrate the second single crystal semiconductor substrate 210 of the display unit 200. The first through holes TSV1 may form a connection path between the first pixel circuit 810 of the driving unit 100 and the second pixel circuit 820 of the display unit 200. The plurality of first through holes TSV1 may be formed to respectively correspond to the sub-pixels SP1, SP2, and SP3 of the display unit 200. In one or more embodiments, the number of first through holes TSV1 may be equal to the number of sub-pixels SP1, SP2, and SP3, and the first through holes TSV1 may be formed to respectively overlap the sub-pixels SP1, SP2, and SP3. Alternatively, the number of first through holes TSV1 may be equal to the number of light emitting elements. However, the present disclosure is not limited thereto. The plurality of first through holes TSV1 may correspond to the respective sub-pixels SP1, SP2, and SP3, but may not necessarily be formed to overlap them. As will be described later, the plurality of sub-pixels SP1, SP2, and SP3 may be connected to the pixel circuit PXC (see FIG. 5) constituted by elements of the first pixel circuit 810 and the second pixel circuit 820 connected through a first through hole TSV1.

In the display device 10 according to one or more embodiments, transistors T1 and T2 (see FIG. 5) included in the pixel circuit PXC and some of a plurality of wires connected thereto may be disposed on different single crystal semiconductor substrates. The display device 10 may include the driving unit 100 and the display unit 200, each including a different single crystal semiconductor substrate, and the transistors of the pixel circuit PXC and the plurality of wires may be dividedly disposed in the driving unit 100 and the display unit 200. Because some wires and some circuit elements of the pixel circuit PXC are dividedly disposed on different single crystal semiconductor substrates, the display device 10 may solve the difficulty of layout design due to high integration density in a small area, and may prevent the formation of parasitic capacitance between adjacent elements. Further, a voltage drop may be efficiently prevented or reduced by eliminating or reducing an unnecessary current path formed in the driving unit 100 and the display unit 200. A more detailed description thereof will be given later with reference to other drawings.

The non-display area NA may be disposed to be around (e.g., to surround) the display area DAA. The non-display area NA may be an area where no pixels PX are disposed and therefore no light is emitted. The common electrode contact area CTA, the pad area PDA, and the plurality of first through hole areas TSA1 may be disposed in the non-display area NA.

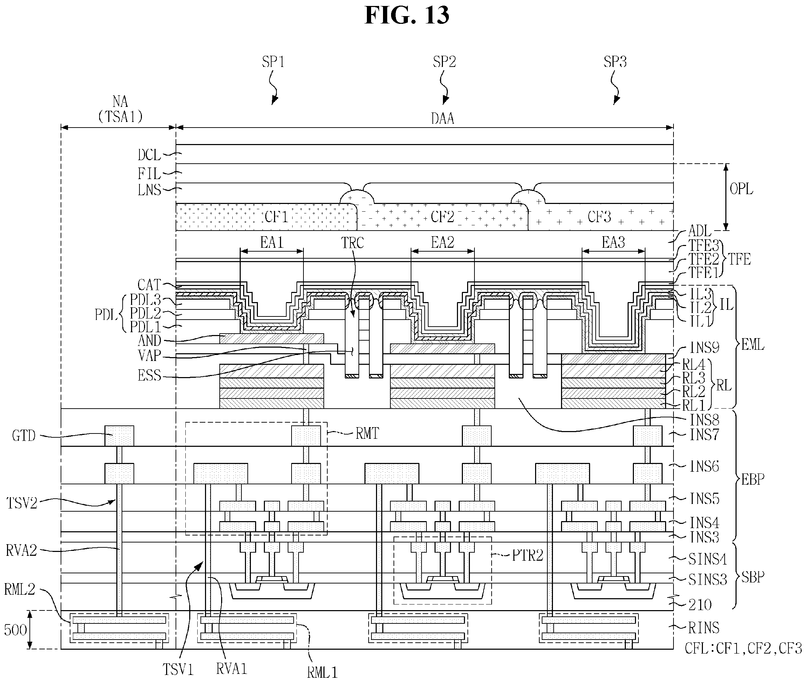

The common electrode contact area CTA may be disposed in the non-display area NA on both sides of the display area DAA in the first direction DR1. For example, the common electrode contact area CTA may be disposed on the left side and the right side of the display area DAA. The common electrode contact area CTA may be an area in which a second electrode CAT (see FIG. 13) of the light emitting element disposed in each of the sub-pixels SP1, SP2, and SP3 of the display area DAA is electrically connected to a first driving voltage line VSL.

The first through hole area TSA1 may be disposed in the non-display area NA on one side of the display area DAA in the second direction DR2. For example, the first through hole area TSA1 may be disposed on the lower side of the display area DAA and between the display area DAA and the pad area PDA. A plurality of second through holes TSV2 may be formed in the first through hole area TSA1. The second through holes TSV2 may be connection paths of signal connection lines that electrically connect the signal terminal STD of the driving unit 100 to the circuit board 300. The plurality of second through holes TSV2 may be formed to respectively correspond to the signal terminals STD of the driving unit 100. In one or more embodiments, the number of second through holes TSV2 may be equal to the number of signal terminals STD, and the second through holes TSV2 may be formed to respectively overlap the signal terminals STD (e.g., in the third direction DR3). However, the present disclosure is not limited thereto. The circuit board 300 may be electrically connected to the signal terminal STD of the driving unit 100 via the plurality of pads PD and the signal connection line disposed in the second through hole TSV2.

The pad area PDA may be disposed on a lower side of the display area DAA, which is one side of the second direction DR2. The plurality of pads PD arranged along the first direction DR1 may be disposed in the pad area PDA. The circuit board 300 may be attached onto the plurality of pads PD. The pads PD may be electrically connected to the circuit board 300, and may serve to transmit the electrical signal applied from the circuit board 300 to the driving unit 100.

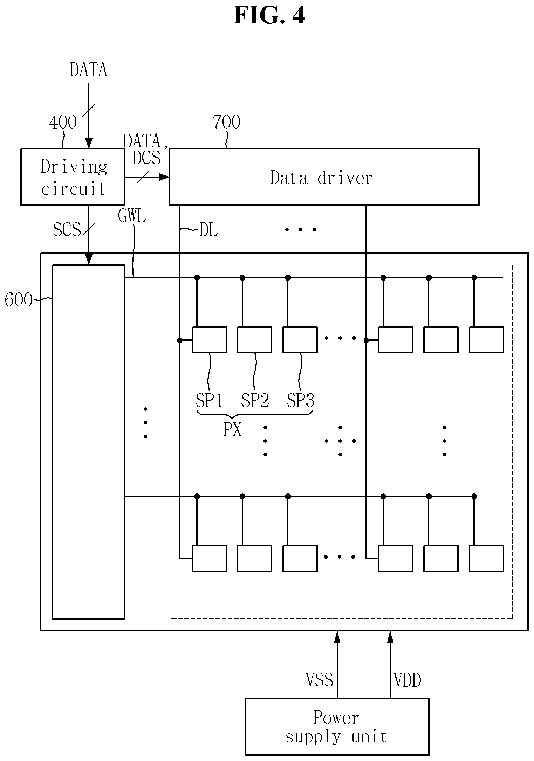

FIG. 4 is a block diagram illustrating a display device according to one or more embodiments.

Referring to FIG. 4, the driving circuit 400 may include a timing control circuit (i.e. a timing controller). In addition, the driving circuit 400 may further include various circuits involved in driving the display device 10, such as a gamma circuit and/or a logic circuit. The driving circuit 400 may include driving circuit transistors formed on the first single crystal semiconductor substrate 110.

The driving circuit 400 may receive digital video data and timing signals from the outside. The timing control circuit may generate a scan timing control signal SCS and a data timing control signal DCS for controlling the display unit 200 in response to the timing signals. The timing control circuit may output the scan timing control signal SCS to the gate driver 600. The timing control circuit may output the digital video data DATA and the data timing control signal DCS to the data driver 700.

A power supply unit may generate a plurality of panel driving voltages by an external power voltage. For example, the power supply unit may generate a first driving voltage VSS and a second driving voltage VDD, and supply them to the plurality of pixels PX.

The scan timing control signal SCS, digital video data DATA, and the data timing control signal DCS of the driving circuit 400 may be supplied to the plurality of pixels PX. The first driving voltage VSS and the second driving voltage VDD of the power supply unit may also be supplied to the plurality of pixels PX.

The gate driver 600 may include a plurality of scan transistors formed on the first single crystal semiconductor substrate 110. The plurality of scan transistors may be formed through a semiconductor process. For example, the plurality of scan transistors may be formed as CMOS transistors. The gate driver 600 may receive the scan timing control signal SCS from the driving circuit 400. The scan driver of the gate driver 600 may generate scan signals according to the scan timing control signal SCS of the driving circuit 400 and output them sequentially to first scan lines GWL.

The data driver 700 may receive the digital video data DATA and the data timing control signal DCS from the driving circuit 400. The data driver 700 converts the digital video data DATA into analog data voltages according to the data timing control signal DCS and outputs the analog data voltages to the data lines DL. In this case, the sub-pixels SP1, SP2, and SP3 are selected by the write scan signal of the gate driver 600, and data voltages may be supplied to the selected sub-pixels SP1, SP2, and SP3.

FIG. 5 is an equivalent circuit diagram of one pixel according to one or more embodiments.

Referring to FIG. 5, the pixel circuit PXC of the sub-pixels SP1, SP2, and SP3 may be connected to the first scan line GWL and the data line DL. Further, the pixel circuit PXC may be connected to the first driving voltage line VSL to which the first driving voltage VSS corresponding to a low potential voltage is applied, and a second driving voltage line VDL to which the second driving voltage VDD corresponding to a high potential voltage is applied. That is, the first driving voltage line VSL may be a low potential voltage line and the second driving voltage line VDL may be a high potential voltage line. In this case, the first driving voltage VSS may be lower than the second driving voltage VDD.

The pixel circuit PXC of the sub-pixels SP1, SP2, and SP3 includes a plurality of transistors T1 and T2, a light emitting element LE, and a first capacitor C1.

The light emitting element LE emits light in response to a driving current Ids flowing through the channel of a first transistor T1. The emission amount of the light emitting element LE may be proportional to the driving current Ids. The light emitting element LE may be disposed between the first transistor T1 and the first driving voltage line VSL. The first electrode of the light emitting element LE may be connected to the drain electrode of the first transistor T1, and the second electrode thereof may be connected to the first driving voltage line VSL. The first electrode of the light emitting element LE may be an anode electrode, and the second electrode of the light emitting element LE may be a cathode electrode. The light emitting element LE may be an organic light emitting diode (OLED) including a first electrode, a second electrode, and an organic light emitting layer disposed between the first electrode and the second electrode, but is not limited thereto. For example, the light emitting element LE may be an inorganic light emitting element including a first electrode, a second electrode, and an inorganic semiconductor disposed between the first electrode and the second electrode, in which case the light emitting element LE may be a micro light emitting diode.

The first transistor T1 may be a driving transistor that controls a source-drain current Ids (hereinafter referred to as "driving current") flowing between the source electrode and the drain electrode thereof according to a voltage applied to the gate electrode thereof. The first transistor T1 includes a gate electrode connected to a first node N1, a source electrode connected to the second driving voltage line VDL, and a drain electrode connected to the light emitting element LE.

A second transistor T2 may be disposed between one electrode of the first capacitor C1 and the data line DL. The second transistor T2 is turned on by the write scan signal of the first scan line GWL to connect the one electrode of the first capacitor C1 to the data line DL. Accordingly, the data voltage of the data line DL may be applied to the one electrode of the first capacitor C1. The second transistor T2 includes a gate electrode connected to the first scan line GWL, a source electrode connected to the data line DL, and a drain electrode connected to the one electrode of the first capacitor C1.

The first capacitor C1 is formed between the first node N1 and the second voltage line VDL. The first capacitor C1 includes one electrode connected to the second voltage line VDL and the other electrode connected to the first node N1. The first node N1 is a contact point between the gate electrode of the first transistor T1, the source electrode of the second transistor T2, and the other electrode of the first capacitor C1.

According to one or more embodiments, in the display device 10, the first transistor T1, the light emitting element LE, the first driving voltage line VSL, and the second driving voltage line VDL may be disposed in the display unit 200, and the second transistor T2 may be disposed in the driving unit 100. The second transistor T2 may be formed on the first single crystal semiconductor substrate 110 of the driving unit 100, and the first transistor T1 may be formed on the second single crystal semiconductor substrate 210 of the display unit 200. The second transistor T2 may be connected to the first node N1 through the first through hole TSV1 formed in the second single crystal semiconductor substrate 210. Accordingly, the data line DL and the first scan line GWL may be disposed in the first pixel circuit 810 of the driving unit 100, and the driving voltage lines VSL and VDL may be disposed in the second pixel circuit 820 of the display unit 200.

Each of the first and second transistors T1 and T2 may be a metal-oxide-semiconductor field effect transistor (MOSFET). For example, each of the first and second transistors T1 and T2 may be a P-type MOSFET, but is not limited thereto. Each of the first and second transistors T1 and T2 may be an N-type MOSFET. Alternatively, some of the first and second transistors T1 and T2 may be P-type MOSFETs, and each of the remaining transistors may be an N-type MOSFET.

Although FIG. 5 illustrates that the pixel circuit PXC of the sub-pixels SP1, SP2, and SP3 includes two transistors T1 and T2 and one capacitor C1, the equivalent circuit diagram of the sub-pixel SP may not be limited to that shown in FIG. 5. For example, the number of transistors and capacitors of the pixel circuit PXC may be greater than that shown in FIG. 5.

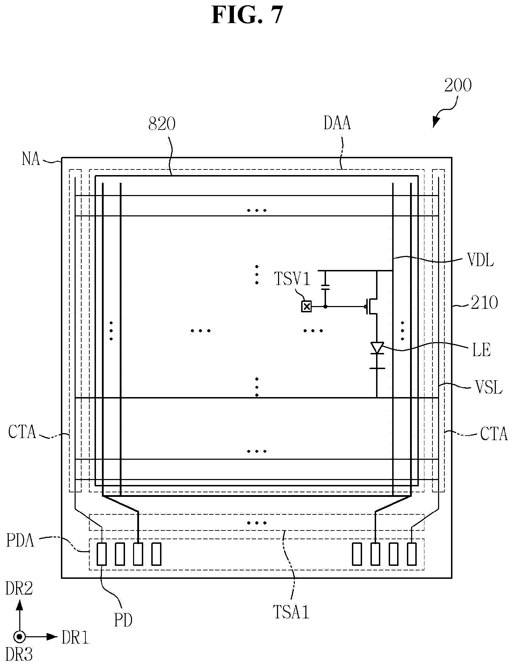

FIG. 6 is a diagram showing wires disposed in a driving unit of a display device according to one or more embodiments. FIG. 7 is a diagram showing connections between a pixel circuit and wires disposed in a display unit of a display device according to one or more embodiments.

Referring to FIGS. 6 and 7, in the driving unit 100 of the display device 10, the plurality of first scan lines GWL and the plurality of data lines DL may be disposed.

The plurality of first scan lines GWL may extend in the first direction DR1 and may be spaced (e.g., spaced apart) from each other along the second direction DR2, and the plurality of data lines DL may extend in the second direction DR2 and may be spaced (e.g., spaced apart) from each other along the first direction DR1. The plurality of data lines DL may extend from the data driver 700 disposed on the lower side of the display area DAA, and the plurality of first scan lines GWL may extend from the gate driver 600 disposed on the right side of the display area DAA. The plurality of first scan lines GWL and data lines DL may be respectively connected to the second transistors T2 formed in the first pixel circuit 810.

In the display unit 200 of the display device 10, the first driving voltage line VSL and the second driving voltage line VDL may be disposed.

The first driving voltage line VSL may include a stem line disposed in the common electrode contact area CTA, and a plurality of horizontal lines branched from the stem line in the first direction DR1 and disposed in the display area DAA. The stem line of the first driving voltage line VSL may be connected to the pad PD of the pad area PDA. The second driving voltage line VDL may include a plurality of vertical lines disposed in the display area DAA, and a horizontal line connected to the plurality of vertical lines in the non-display area NA. The horizontal line of the second driving voltage line VDL may be connected to the pad PD of the pad area PDA. In the display area DAA, the plurality of horizontal lines of the first driving voltage line VSL and the plurality of vertical lines of the second driving voltage line VDL may be disposed in a mesh type.

The plurality of first transistors T1 and first capacitors C1 may be formed in the second pixel circuit 820 disposed in the display area DAA. The first transistor T1 and the first capacitor C1 may be electrically connected to the second transistor T2 of the driving unit 100 through the first through hole TSV1. The first transistor T1 may be electrically connected to the light emitting element LE disposed in a display element layer EML (see FIG. 13) to be described later. Further, the first transistor T1 may be electrically connected to the second driving voltage line VDL, and the light emitting element LE may be electrically connected to the first driving voltage line VSL. The first transistor T1, the second transistor T2, and the first capacitor C1 may constitute the pixel circuit PXC corresponding to each of the sub-pixels SP1, SP2, and SP3 of the display device 10, and they may be respectively connected to the driving voltage lines VSL and VDL.

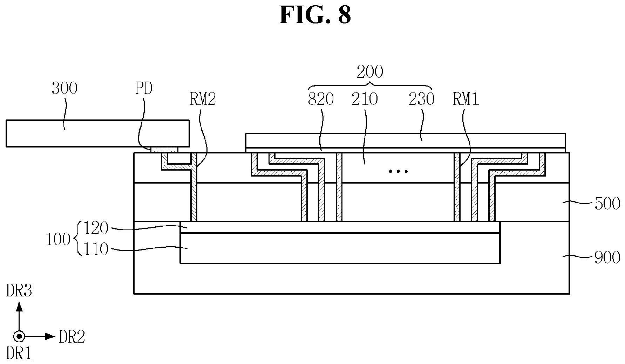

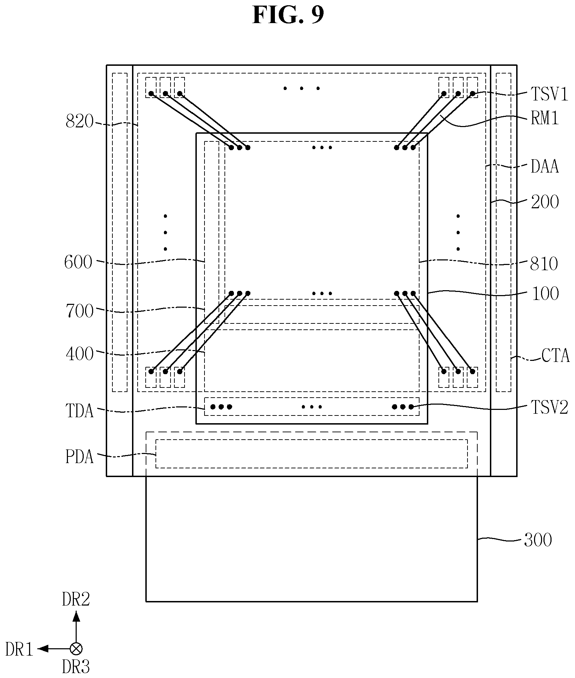

FIG. 8 is a schematic cross-sectional view of a display device according to one or more embodiments. FIG. 9 is a schematic diagram showing a rear surface of a display device according to one or more embodiments. FIG. 8 shows a schematic connection relationship of routing lines RM1 and RM2 that electrically connect the display unit 200 to the driving unit 100. FIG. 9 shows a disposition of the through holes TSV1 and TSV2 and the routing lines RM1 and RM2 viewed from the rear of the display device 10.

Referring to FIGS. 8 and 9 in conjunction with FIGS. 2 and 3, the display device 10 according to one or more embodiments may include the driving unit 100 including the first single crystal semiconductor substrate 110 and a driving circuit layer 120 disposed on the first single crystal semiconductor substrate 110; and the display unit 200 including the second single crystal semiconductor substrate 210 and the second pixel circuit 820 and a display layer 230 disposed on the second single crystal semiconductor substrate 210. The display device 10 may include the two different single crystal semiconductor substrates 110 and 210 overlapping each other in the third direction DR3, which is the thickness direction of the display device 10.

The driving unit 100 may include circuit elements necessary for light emission of the light emitting elements included in the display layer 230 of the display unit 200. As described above, the driving circuit layer 120 of the driving unit 100 may include the driving circuit 400, the gate driver 600, the data driver 700, the first pixel circuit 810 and so forth, and the circuit elements constituting them, such as the second transistor T2 and the scan transistor, may be formed of CMOS on the first single crystal semiconductor substrate 110. Further, the plurality of first scan lines GWL and data lines DL may be disposed in the driving circuit layer 120.

The display unit 200 may include some of the circuit elements required for light emission of the light emitting elements and the plurality of light emitting elements that emit light to display an image of the display device 10. The display unit 200 may include the second pixel circuit 820 in which circuit elements constituting the pixel circuit PXC are disposed. The second pixel circuit 820 may include some of the circuit elements constituting the pixel circuit, such as the first transistor T1 and the first capacitor C1 of FIG. 5, and the plurality of driving voltage lines VSL and VDL may be disposed therein. The first transistor T1 may be formed of CMOS in the second single crystal semiconductor substrate 210. The light emitting elements may be electrically connected to the circuit elements formed in the second pixel circuit 820 of the display unit 200, and the first pixel circuit 810 or the driving circuit layer 120 of the driving unit 100 to emit light.

According to one or more embodiments, in the display device 10, in a plan view, the area of the driving unit 100 or the first single crystal semiconductor substrate 110 may be smaller than the area of the display unit 200 or the second single crystal semiconductor substrate 210. A plurality of transistors formed in the driving unit 100 may be formed through a semiconductor micro-process, and thus may have a very small size or line width. The driving unit 100 may be desirable because a large number of circuit elements may be disposed with a high integration density, and power consumption may be reduced due to the miniaturization of the elements.

In addition, because the driving unit 100 includes only the circuit elements formed of CMOS on the first single crystal semiconductor substrate 110 and does not include light emitting elements, the driving unit 100 only needs to secure a space for accommodating the elements formed by the micro-process therein. It still works even if the first single crystal semiconductor substrate 110 has a smaller area than the second single crystal semiconductor substrate 210, and a large number of driving units 100 may be fabricated on a single wafer substrate on which the process of forming the driving circuit layer 120 is performed, so that the fabrication yield may be improved. In particular, because a high-cost semiconductor process is performed to fabricate the driving unit 100, such improvement in the fabrication yield of the driving unit 100 may lead to cost reduction. Further, in the display unit 200, because a large number of light emitting elements can be formed on the second single crystal semiconductor substrate 210 having a relatively large area, a high-resolution display device may be implemented.

The display device 10 may include a connection wiring layer 500 disposed between the second single crystal semiconductor substrate 210 of the display unit 200 and the driving circuit layer 120 of the driving unit 100. The connection wiring layer 500 may be disposed on the bottom surface of the second single crystal semiconductor substrate 210. The plurality of routing lines RM1 and RM2 may be partially disposed in the connection wiring layer 500. The routing lines RM1 and RM2 may connect the second pixel circuit 820 of the display unit 200 and the circuit board 300 to the driving unit 100. The driving circuit layer 120 of the driving unit 100 may be electrically connected to the display unit 200 and the circuit board 300 through the routing lines RM1 and RM2 of the connection wiring layer 500 to transmit an electrical signal for light emission.

The first routing line RM1 may be connected to the second pixel circuit 820 of the display unit 200 and the first pixel circuit 810 (or driving circuit layer 120) of the driving unit 100. In one or more embodiments, the display device 10 may include the plurality of first through holes TSV1 disposed to correspond to the sub-pixels SP1, SP2, and SP3 of the display unit 200, and the first routing line RM1 may be disposed in the first through holes TSV1 to connect the first pixel circuit 810 and the second pixel circuit 820. For example, the first routing line RM1 may connect the second transistor T2 of the first pixel circuit 810 and the first transistor T1 of the second pixel circuit 820. The first through hole TSV1 may be disposed throughout the second pixel circuit 820 of the display unit 200 having a larger area, whereas the first pixel circuit 810 of the driving unit 100 may have a relatively smaller area. The first routing line RM1 may include conductive vias RVA1 (see FIG. 13) disposed throughout the display unit 200 having the large area and connection lines RML1 (see FIG. 13) connecting them to the first pixel circuit 810 having the smaller area. The distance between the first routing line RM1 and the neighboring first routing line RM1 may be narrower in the portion overlapping the driving unit 100 than in the portion overlapping the display area DAA in a plan view.

In one or more embodiments, some of the first through holes TSV1 may overlap the driving unit 100 in the thickness direction (e.g., the third direction DR3), and others may not overlap the driving unit 100 in the thickness direction (e.g., the third direction DR3). As for the first routing line RM1 disposed in the first through holes TSV1 that do not overlap the driving unit 100, a portion of the connection line RML1 (see FIG. 13) may not overlap the driving unit 100. However, the disposition of the first through holes TSV1 may vary according to the location of the layer where the connection lines RML1 of the first routing lines RM1 are disposed.

According to one or more embodiments, the number of first through holes TSV1 may be equal to the number of the sub-pixels SP1, SP2, and SP3 disposed in the display area DAA. For example, the plurality of sub-pixels SP1, SP2, and SP3 may be arranged along the first direction DR1 and the second direction DR2 in the display area DAA. The first through holes TSV1 may also be arranged along the first direction DR1 and the second direction DR2 and may correspond one-to-one to the respective sub-pixels SP1, SP2, and SP3. The first through holes TSV1 may be formed to respectively overlap the sub-pixels SP1, SP2, and SP3. The number of first routing lines RM1 may be equal to the number of sub-pixels SP1, SP2, and SP3.

The plurality of second through holes TSV2 may be disposed in the first through hole area TSA1 of the display unit 200 and may be formed to overlap the signal terminal area TDA of the driving unit 100. The second routing line RM2 connected to the signal terminal STD of the driving unit 100 may be disposed in the second through holes TSV2. Unlike the first through hole TSV1, the second through hole TSV2 may be formed to overlap each signal terminal STD of the driving unit 100. Accordingly, the second routing line RM2 may also be disposed to correspond to and overlap each signal terminal STD. The second routing line RM2 may be a wire that transmits a signal applied from the circuit board 300 to the driving unit 100.

Hereinafter, the structure of the driving circuit layer 120 of the driving unit 100 and the display layer 230 of the display unit 200 will be described in detail with reference to other drawings.

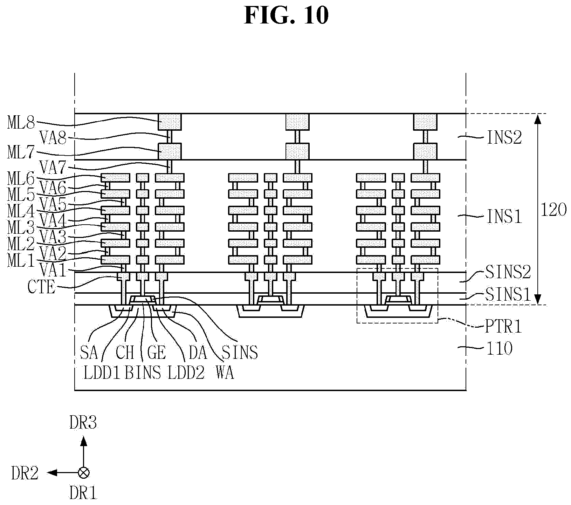

FIG. 10 is a schematic cross-sectional view of a driving unit according to one or more embodiments.

Referring to FIG. 10, the driving unit 100 may include the first single crystal semiconductor substrate 110 and the driving circuit layer 120 disposed thereon.

The first single crystal semiconductor substrate 110 may be a silicon substrate, a germanium substrate, and/or a silicon-germanium substrate. The first single crystal semiconductor substrate 110 may be a substrate doped with a first type impurity. A plurality of well regions WA may be disposed on the top surface of the first single crystal semiconductor substrate 110. The plurality of well regions WA may be regions doped with a second type impurity. The second type impurity may be different from the aforementioned first type impurity. For example, when the first type impurity is a p-type impurity, the second type impurity may be an n-type impurity. Alternatively, when the first type impurity is an n-type impurity, the second type impurity may be a p-type impurity.

Each of the plurality of well regions WA includes a source region SA corresponding to the source electrode of a first transistor PTR1, a drain region DA corresponding to the drain electrode thereof, and a channel region CH disposed between the source region SA and the drain region DA.

A lower insulating film BINS may be disposed between a gate electrode GE and the well region WA. A side insulating film SINS may be disposed on the side surface of the gate electrode GE. The side insulating film SINS may be disposed on the lower insulating film BINS.

Each of the source region SA and the drain region DA may be a region doped with the first type impurity. The gate electrode GE of the first transistor PTR1 may overlap the well region WA in the third direction DR3. The channel region CH may overlap the gate electrode GE in the third direction DR3. The source region SA may be disposed on one side of the gate electrode GE, and the drain region DA may be disposed on the other side of the gate electrode GE.

Each of the plurality of well regions WA further includes a first low-concentration impurity region LDD1 disposed between the channel region CH and the source region SA, and a second low-concentration impurity region LDD2 disposed between the channel region CH and the drain region DA. The first low-concentration impurity region LDD1 may be a region having a lower impurity concentration than the source region SA due to the lower insulating film BINS. The second low-concentration impurity region LDD2 may be a region having a lower impurity concentration than the drain region DA due to the lower insulating film BINS. The distance between the source region SA and the drain region DA may increase due to the presence of the first low-concentration impurity region LDD1 and the second low-concentration impurity region LDD2. Therefore, the length of the channel region CH of each of the first transistors PTR1 may increase, so that punch-through and hot carrier phenomena that might be caused by a short channel may be prevented.

The first single crystal semiconductor substrate 110 may include the plurality of first transistors PTR1 constituting a plurality of circuit elements of the driving unit 100. The first transistors PTR1 formed on the first single crystal semiconductor substrate 110 may constitute the driving circuit 400, the gate driver 600, the data driver 700, and the first pixel circuit 810.

When the driving circuit layer 120 is formed on a silicon wafer substrate, a process of reducing the thickness of the first single crystal semiconductor substrate 110 may be performed. The first single crystal semiconductor substrate 110 may have a thickness smaller than that of a wafer substrate on which a semiconductor process for forming the driving circuit layer 120 is performed. In one or more embodiments, the thickness of the first single crystal semiconductor substrate 110 may be 100 µm or less, for example, in the range of 80 µm to 100 µm.

The driving circuit layer 120 may include a first semiconductor insulating layer SINS1, a second semiconductor insulating layer SINS2, a plurality of contact electrodes CTE, a first interlayer insulating layer INS1, a second interlayer insulating layer INS2, a plurality of conductive layers ML1 to ML8, and a plurality of vias VA1 to VA8. The driving circuit layer 120 may include wires electrically connected to the plurality of first transistors PTR1 included in the first single crystal semiconductor substrate 110.

The first semiconductor insulating layer SINS1 and the second semiconductor insulating layer SINS2 may be disposed on the first single crystal semiconductor substrate 110. The first semiconductor insulating layer SINS1 may be an insulating layer disposed on the first single crystal semiconductor substrate 110 and the gate electrode GE of the first transistor PTR1, and the second semiconductor insulating layer SINS2 may be an insulating layer disposed on the gate electrode GE of the first transistor PTR1 and the first semiconductor insulating layer SINS1. The first semiconductor insulating layer SINS1 and the second semiconductor insulating layer SINS2 may be formed of a silicon carbon nitride (SiCN) and/or silicon oxide (SiOₓ)-based inorganic film, but are not limited thereto. In the drawing, the first semiconductor insulating layer SINS1 and the second semiconductor insulating layer SINS2 are each provided for example as a single layer having a suitable thickness (e.g., a predetermined thickness), but are not limited thereto. The first semiconductor insulating layer SINS1 and the second semiconductor insulating layer SINS2 may have a structure in which one or more layers are stacked on top of each other.

The plurality of contact electrodes CTE may be disposed on the first single crystal semiconductor substrate 110. The plurality of contact electrodes CTE may be connected to one of the gate electrodes GE, the source region SA, or the drain region DA of each first transistor PTR1 formed on the first single crystal semiconductor substrate 110 through holes penetrating the first and second semiconductor insulating layers SINS1 and SINS2. The plurality of contact electrodes CTE may be formed of copper (Cu), aluminum (Al), tungsten (W), molybdenum (Mo), chromium (Cr), gold (Au), titanium (Ti), nickel (Ni), and/or neodymium (Nd), and/or an alloy including any one of them. The top surfaces of the plurality of contact electrodes CTE may be exposed without being covered by the first and second semiconductor insulating layers SINS1 and SINS2.

The first interlayer insulating layer INS1 may be disposed on the plurality of contact electrodes CTE and the first and second semiconductor insulating layers SINS1 and SINS2. The second interlayer insulating layer INS2 may be disposed on the first interlayer insulating layer INS1. Each of the first interlayer insulating layer INS1 and the second interlayer insulating layer INS2 may be formed of silicon carbonitride (SiCN) and/or a silicon oxide (SiOx)-based inorganic film, but is not limited thereto. Although it is illustrated in the drawings that each of the first interlayer insulating layer INS1 and the second interlayer insulating layer INS2 is formed as a single layer, the present disclosure is not limited thereto. Each of the first interlayer insulating layer INS1 and the second interlayer insulating layer INS2 may have a structure in which one or more layers are stacked on top of each other, and may be disposed between a plurality of first to eighth conductive layers ML1 to ML8 to be described later.

The first to eighth conductive layers ML1 to ML8 and first to eighth vias VA1 to VA8 may be electrically connected to the plurality of contact electrodes CTE to form the driving circuit 400 or the data driver 700 of the driving unit 100. The plurality of first transistors PTR1 formed on the first single crystal semiconductor substrate 110 may be electrically connected to each other through the first to eighth conductive layers ML1 to ML8 and the first to the eighth vias VA1 to VA8, and may form the driving circuit 400, and the data driver 700 of the driving unit 100.

The first conductive layer ML1 may be connected to the contact electrode CTE through the first via VA1. The first conductive layer ML1 may be disposed on the contact electrode CTE, and the first via VA1 may be disposed between the first conductive layer ML1 and the contact electrode CTE to be in contact with both of them. The second conductive layer ML2 may be connected to the first conductive layer ML1 through the second via VA2. The second conductive layer ML2 may be disposed on the first conductive layer ML1, and the second via VA2 may be disposed between the first conductive layer ML1 and the second conductive layer ML2 to be in contact with both of them.

The third conductive layer ML3 may be connected to the second conductive layer ML2 through the third via VA3. The fourth conductive layer ML4 may be connected to the third conductive layer ML3 through the fourth via VA4, the fifth conductive layer ML5 may be connected to the fourth conductive layer ML4 through the fifth via VA5, and the sixth conductive layer ML6 may be connected to the fifth conductive layer ML5 through the sixth via VA6. The third conductive layer ML3, the fourth conductive layer ML4, the fifth conductive layer ML5, and the sixth conductive layer ML6 may be sequentially disposed on the second conductive layer ML2, and the third via VA3, the fourth via VA4, the fifth via VA5, and the sixth via VA6 may be disposed between them. The third to sixth vias VA3 to VA6 may be in contact with different metal layers disposed above and below them, respectively. The seventh via VA7 may be disposed on the sixth conductive layer ML6. The seventh via VA7 may be in contact with the seventh conductive layer ML7 and the sixth conductive layer ML6 disposed thereon.

The first to sixth conductive layers ML1 to ML6 and the first to seventh vias VA1 to VA7 may be disposed in the first interlayer insulating layer INS1. The first to sixth conductive layers ML1 to ML6 and the first to seventh vias VA1 to VA7 may constitute a first driving circuit layer disposed in the first interlayer insulating layer INS1 of the driving circuit layer 120.

The seventh conductive layer ML7 may be connected to the sixth conductive layer ML6 through the seventh via VA7. The seventh conductive layer ML7 may be disposed on the first interlayer insulating layer INS1 and the sixth conductive layer ML6, and the seventh via VA7 may be disposed between the sixth conductive layer ML6 and the seventh conductive layer ML7 to be in contact with both of them. The eighth conductive layer ML8 may be connected to the seventh conductive layer ML7 through the eighth via VA8. The eighth conductive layer ML8 is disposed on the seventh conductive layer ML7, and the eighth via VA8 may be disposed between the seventh conductive layer ML7 and the eighth conductive layer ML8 to be in contact with both of them. The top surface of the eighth conductive layer ML8 may be exposed without being covered by the second interlayer insulating layer INS2, and may be electrically connected to the routing lines RM disposed in the display unit 200.

The seventh conductive layer ML7, the eighth via VA8, and the eighth conductive layer ML8 may be disposed in the second interlayer insulating layer INS2. The seventh conductive layer ML7, the eighth via VA8, and the eighth conductive layer ML8 may constitute a second driving circuit layer disposed in the second interlayer insulating layer INS2 of the driving circuit layer 120.

In the drawings, although the first to eighth conductive layers ML1 to ML8 and the first to eighth vias VA1 to VA8 are illustrated as being sequentially stacked on top of each other, their layout and connection may be modified in various ways according to the circuits of the driving circuit 400, and the data driver 700 of the driving unit 100. The connection structure shown in the drawings is nothing more than an example, and the connection of the driving circuit layer 120 disposed in the driving unit 100 of the display device 10 is not limited thereto. In addition, the driving circuit layer 120 may not necessarily include the first to eighth conductive layers ML1 to ML8 and the first to eighth vias VA1 to VA8, and some of these layers may be omitted or more layers may be provided.

The first to eighth conductive layers ML1 to ML8 and the first to eighth vias VA1 to VA8 may be formed of substantially the same material. For example, the first to eighth conductive layers ML1 to ML8 and the first to eighth vias VA1 to VA8 may be formed of copper (Cu), aluminum (Al), tungsten (W), molybdenum (Mo), chromium (Cr), gold (Au), titanium (Ti), nickel (Ni), and/or neodymium (Nd), and/or an alloy including any one of them.

The thicknesses of the first conductive layer ML1, the second conductive layer ML2, the third conductive layer ML3, the fourth conductive layer ML4, the fifth conductive layer ML5, and the sixth conductive layer ML6 may be larger than the thicknesses of the first via VA1, the second via VA2, the third via VA3, the fourth via VA4, the fifth via VA5, and the sixth via VA6, respectively. The thickness of each of the second conductive layer ML2, the third conductive layer ML3, the fourth conductive layer ML4, the fifth conductive layer ML5, and the sixth conductive layer ML6 may be substantially the same or larger than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be substantially the same. For example, the thickness of the first conductive layer ML1 may be approximately 1360 Å; the thickness of each of the second conductive layer ML2, the third conductive layer ML3, the fourth conductive layer ML4, the fifth conductive layer ML5, and the sixth conductive layer ML6 may be approximately 1440 Å; and the thickness of each of the first via VA1, the second via VA2, the third via VA3, the fourth via VA4, the fifth via VA5, and the sixth via VA6 may be approximately 1150 Å.

The thickness of each of the seventh conductive layer ML7 and the eighth conductive layer ML8 may be larger than the thickness of the first conductive layer ML1, the thickness of the second conductive layer ML2, the thickness of the third conductive layer ML3, the thickness of the fourth conductive layer ML4, the thickness of the fifth conductive layer ML5, and the thickness of the sixth conductive layer ML6. The thickness of the seventh conductive layer ML7 and the thickness of the eighth conductive layer ML8 may be larger than the thickness of the seventh via VA7 and the thickness of the eighth via VA8, respectively. The thickness of each of the seventh via VA7 and the eighth via VA8 may be larger than the thickness of the first via VA1, the thickness of the second via VA2, the thickness of the third via VA3, the thickness of the fourth via VA4, the thickness of the fifth via VA5, and the thickness of the sixth via VA6. The thickness of the seventh conductive layer ML7 and the thickness of the eighth conductive layer ML8 may be substantially the same. For example, the thickness of each of the seventh conductive layer ML7 and the eighth conductive layer ML8 may be approximately 9000 Å. The thickness of each of the seventh via VA7 and the eighth via VA8 may be approximately 6000 Å.

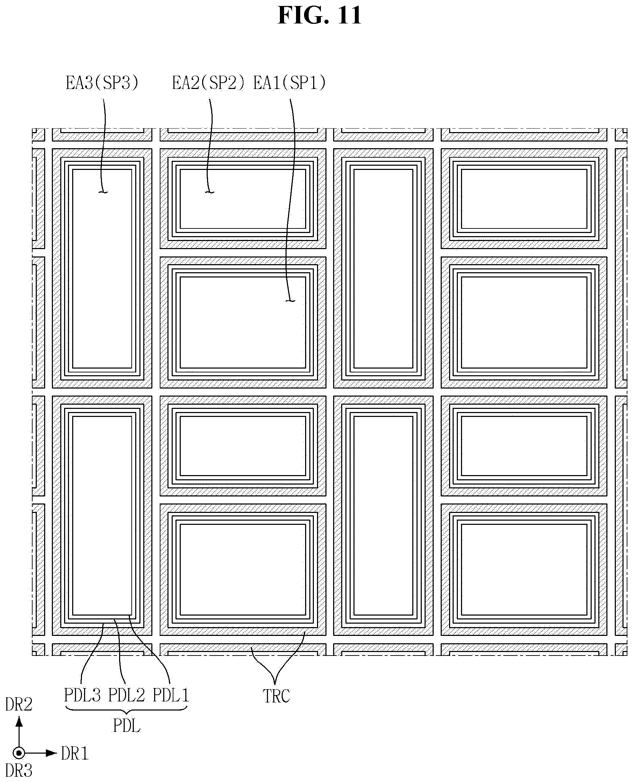

FIG. 11 is a plan view showing a pixel defining film, and first electrodes and emission areas of a plurality of sub-pixels disposed in a display area of a display unit according to one or more embodiments.

Referring to FIG. 11, each of the plurality of pixels PX may include a first sub-pixel SP1, a second sub-pixel SP2, and a third sub-pixel SP3. The first to third sub-pixels SP1, SP2, and SP3 may include emission areas EA1, EA2, and EA3, respectively. For example, the first sub-pixel SP1 may include the first emission area EA1, the second sub-pixel SP2 may include the second emission area EA2, and the third sub-pixel SP3 may include the third emission area EA3.

Each of the first emission area EA1, the second emission area EA2, and the third emission area EA3 may have, in a plan view, a quadrilateral shape such as a rectangle, a square, or a diamond. For example, the third emission area EA3 may have a rectangular shape, in a plan view, having a short side in the first direction DR1 and a long side in the second direction DR2. In addition, each of the second emission area EA2 and the first emission area EA1 may have a rectangular shape, in a plan view, having a long side in the first direction DR1 and a short side in the second direction DR2.

Each of the first emission area EA1, the second emission area EA2, and the third emission area EA3 may be an area defined by a pixel defining film PDL. For example, each of the first emission area EA1, the second emission area EA2, and the third emission area EA3 may be an area defined by a first pixel defining film PDL1.

The length of the third emission area EA3 in the first direction DR1 may be smaller than the length of the first emission area EA1 in the first direction DR1, and may be smaller than the length of the second emission area EA2 in the first direction DR1. The length of the first emission area EA1 in the first direction DR1 and the length of the second emission area EA2 in the first direction DR1 may be substantially the same.

In each of the plurality of pixels PX, the first emission area EA1 and the second emission area EA2 may be adjacent to each other in the second direction DR2. Further, the first emission area EA1 and the third emission area EA3 may be adjacent to each other in the first direction DR1. Further, the second emission area EA2 and the third emission area EA3 may be adjacent to each other in the first direction DR1. The area of the first emission area EA1, the area of the second emission area EA2, and the area of the third emission area EA3 may be different.

Although it is illustrated in the drawing that each of the first emission area EA1, the second emission area EA2, and the third emission area EA3 has a rectangular shape in a plan view, the present disclosure is not limited thereto. For example, each of the first emission area EA1, the second emission area EA2, and the third emission area EA3 may have a polygonal shape other than a quadrilateral shape, a circular shape, or an elliptical shape in a plan view.

The first emission area EA1 may emit first light, the second emission area EA2 may emit second light, and the third emission area EA3 may emit third light. Here, the first light may be light of a red wavelength band, the second light may be light of a green wavelength band, and the third light may be light of a blue wavelength band. For example, the blue wavelength band may be a wavelength band of light whose main peak wavelength is in the range of about 370 nm to about 460 nm, the green wavelength band may be a wavelength band of light whose main peak wavelength is in the range of about 480 nm to about 560 nm, and the red wavelength band may be a wavelength band of light whose main peak wavelength is in the range of about 600 nm to about 750 nm.

A first electrode AND (e.g., see FIG. 13) of the light emitting element may have a rectangular shape in a plan view. The planar shape of the first electrode AND of the light emitting element may be different in the first sub-pixel SP1, the second sub-pixel SP2, and the third sub-pixel SP3. For example, the first electrode AND of the first sub-pixel SP1 and the first electrode AND of the second sub-pixel SP2 may have a rectangular planar shape having a long side in the first direction DR1 and a short side in the second direction DR2. The first electrode AND of the third sub-pixel SP3 may have a rectangular shape, in a plan view, having a short side in the first direction DR1 and a long side in the second direction DR2. The length of the first electrode AND of the third sub-pixel SP3 in the first direction DR1 may be shorter than the length of the first electrode AND of each of the first sub-pixel SP1 and the second sub-pixel SP2 in the second direction DR2. The length of the first electrode AND of the first sub-pixel SP1 in the second direction DR2 may be longer than the length of the first electrode AND of the second sub-pixel SP2 in the second direction DR2.

The first electrode AND of the light emitting element may be connected to a reflective electrode layer RL (see FIG. 13) via an electrode via VAP. The electrode via VAP may overlap the first pixel defining film PDL1, a second pixel defining film PDL2, and a third pixel defining film PDL3 in the third direction DR3.

At least one trench TRC may be a structure for cutting off at least one charge generation layer of a light emitting stack IL between the neighboring emission areas EA1, EA2, and EA3. At least one trench TRC may be disposed between the first emission area EA1 and the second emission area EA2, between the first emission area EA1 and the third emission area EA3, and between the second emission area EA2 and the third emission area EA3. More specifically, at least one trench TRC may be disposed between the first electrode AND of the first sub-pixel SP1 and the first electrode AND of the second sub-pixel SP2, between the first electrode AND of the first sub-pixel SP1 and the first electrode AND of the third sub-pixel SP3, and between the first electrode AND of the second sub-pixel SP2 and the first electrode AND of the third sub-pixel SP3.

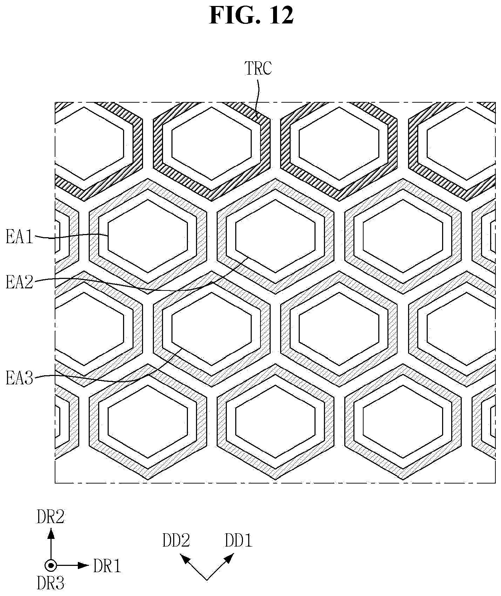

FIG. 12 is a plan view showing a pixel defining film, and first electrodes and emission areas of a plurality of sub-pixels disposed in a display area of a display unit according to one or more embodiments.

Referring to FIG. 12, the embodiment of FIG. 12 is substantially the same as the embodiment of FIG. 11 except that the planar shapes of the first emission area EA1, the second emission area EA2, and the third emission area EA3 are different from those of the embodiment of FIG. 11, description overlapping with the embodiment of FIG. 11 will be omitted.

The first emission area EA1, the second emission area EA2, and the third emission area EA3 may be disposed in a hexagonal structure having a hexagonal shape in a plan view. In this case, the first emission area EA1 and the second emission area EA2 may be adjacent to each other in the first direction DR1, but the second emission area EA2 and the third emission area EA3 may be adjacent to each other in a first diagonal direction DD1, and the first emission area EA1 and the third emission area EA3 may be adjacent to each other in a second diagonal direction DD2. The first diagonal direction DD1 may be a direction between the first direction DR1 and the second direction DR2, and may refer to a direction inclined by 45 degrees with respect to the first direction DR1 and the second direction DR2, and the second diagonal direction DD2 may be a direction perpendicular to the first diagonal direction DD1.

Although it is illustrated in FIGS. 11 and 12 that each of the plurality of pixels PX includes the three emission areas EA1, EA2, and EA3, the present disclosure is not limited thereto. That is, each of the plurality of pixels PX may include four emission areas.

In addition, the layout of the emission areas of the plurality of pixels PX is not limited to that illustrated in the drawing. For example, the emission areas of the plurality of pixels PX may be disposed in a stripe structure in which the emission areas are arranged along the first direction DR1, a PENTILE^{®} structure in which the emission areas are arranged in a diamond shape, or a hexagonal structure in which the emission areas having, in a plan view, a hexagonal shape are arranged side by side. PENTILE^{®} is a registered trademark of Samsung Display Co., Ltd., Republic of Korea.

FIG. 13 is a cross-sectional view illustrating a portion of a display unit according to one or more embodiments. FIG. 13 shows a schematic cross-sectional structure of the first through hole area TSA1 of the non-display area NA and the display area DAA.

Referring to FIG. 13, the display unit 200 may include a semiconductor backplane SBP, a pixel circuit backplane EBP, the display element layer EML, an encapsulation layer TFE, an adhesive layer ADL, an optical layer OPL, and a cover layer DCL. The semiconductor backplane SBP and the pixel circuit backplane EBP of the display unit 200 may constitute the second pixel circuit 820. The display element layer EML, the encapsulation layer TFE, the adhesive layer ADL, and the optical layer OPL of the display unit 200 may constitute the display layer 230. In one or more embodiments, the display unit 200 may further include a polarizing plate disposed on the cover layer DCL. The connection wiring layer 500 may be disposed between the first single crystal semiconductor substrate 110 and the second single crystal semiconductor substrate 210 of the semiconductor backplane SBP. Alternatively, the connection wiring layer 500 may be disposed between the display element layer EML and the first single crystal semiconductor substrate 110.

The semiconductor backplane SBP includes the second single crystal semiconductor substrate 210 including a plurality of second transistors PTR2, a plurality of semiconductor insulating films disposed on the plurality of second transistors PTR2, and the plurality of contact electrodes CTE respectively electrically connected to the plurality of pixel transistors. The plurality of second transistors PTR2 may be the first transistor T1 constituting the pixel circuit of FIG. 5.

The second single crystal semiconductor substrate 210 may be a silicon substrate, a germanium substrate, and/or a silicon-germanium substrate. The second single crystal semiconductor substrate 210 may be a substrate doped with an impurity. The plurality of well regions WA may be disposed on the top surface of the second single crystal semiconductor substrate 210. The plurality of well regions WA may be regions doped with a second type impurity. The second type impurity may be different from the aforementioned first type impurity. For example, when the first type impurity is a p-type impurity, the second type impurity may be an n-type impurity. Alternatively, when the first type impurity is an n-type impurity, the second type impurity may be a p-type impurity.

The second single crystal semiconductor substrate 210 may include the plurality of second transistors PTR2, similarly to the first single crystal semiconductor substrate 110. The structure of the second transistor PTR2 may be the same as that of the first transistor PTR1, and therefore, a detailed description thereof will be omitted.

In the display device 10, wafer substrates on which the first transistor PTR1 formed on the first single crystal semiconductor substrate 110 of the driving unit 100, and the second transistor PTR2 formed on the second single crystal semiconductor substrate 210 of the display unit 200 are formed may be different. According to one or more embodiments, in the display device 10, the first transistor PTR1 formed on the first single crystal semiconductor substrate 110 and the second transistor PTR2 formed on the second single crystal semiconductor substrate 210 may have different sizes, line widths, and/or the like.

For example, in the display device 10, the minimum line width of the first transistor PTR1 formed on the first single crystal semiconductor substrate 110 may be smaller than the minimum line width of the second transistor PTR2 formed on the second single crystal semiconductor substrate 210. The semiconductor process performed on a first wafer substrate for the formation of the first transistor PTR1 is a process having higher resolution than the semiconductor process performed on a second wafer substrate for the formation of the second transistor PTR2, and thus the size of an element such as a fabricated transistor may be smaller. In other words, the semiconductor process performed on the first wafer substrate may be a finer process than the semiconductor process performed on the second wafer substrate.

As described above, the first single crystal semiconductor substrate 110 of the driving unit 100 may have a smaller area in a plan view than the second single crystal semiconductor substrate 210 of the display unit 200, and small-sized elements may be disposed with a high integration density to reduce power consumption and improve fabrication yield. On the other hand, the second single crystal semiconductor substrate 210 of the display unit 200 may have a larger area in a plan view than the first single crystal semiconductor substrate 110, and a process with a relatively large linewidth may be performed. The second transistors PTR2 disposed in the second single crystal semiconductor substrate 210 may be formed in a larger area than when formed in the first single crystal semiconductor substrate 110, and the second transistors PTR2 constituting the pixel circuit may not require a high integration density. Accordingly, the semiconductor process performed on the first wafer substrate may be performed as a high-cost process having a small line width, and the semiconductor process performed on the second wafer substrate may be performed as a low-cost process having a relatively large line width.

In one or more embodiments, the lengths of the channel regions CH of the plurality of transistors PTR1 and PTR2 may be different from each other, and the minimum line width or a length of the channel region CH of the first transistor PTR1 may be smaller than the minimum line width or a length of the channel region CH of the second transistor PTR2. The minimum line width or the length of the channel region CH of the first transistor PTR1 may be equal to or less than 100 nm, or may range from 2 nm to 80 nm. The minimum line width or the length of the channel region CH of the second transistor PTR2 may be greater than or equal to 100 nm, or may range from 100 nm to 5 µm.

The second single crystal semiconductor substrate 210 may include the plurality of first through holes TSV1 that are spaced (e.g., spaced apart) from each other. The first through hole TSV1 may penetrate the second single crystal semiconductor substrate 210 from the top surface to the bottom surface thereof. A first conductive via RVA1 of the first routing line RM1 may be disposed in the first through hole TSV1. The first through hole TSV1 may form the connection path of the first routing lines RM1 that electrically connect the first pixel circuit 810 of the driving unit 100 to the second pixel circuit 820 of the display unit 200.

The second single crystal semiconductor substrate 210 may include the plurality of second through holes TSV2 formed in the non-display area NA, and the second conductive vias RVA2 of the second routing lines RM2 may be disposed in the second through holes TSV2, respectively. The circuit board 300 may be electrically connected to the signal terminal STD of the driving unit 100 via the second routing line RM2. The second conductive via RVA2 may form a connection path of the second routing lines RM2 connecting the circuit board 300 and the signal terminal STD of the driving unit 100.

In one or more embodiments, the through holes TSV1 and TSV2 of the second single crystal semiconductor substrate 210 may be formed through a through silicon via (TSV) process in which a hole that penetrates the wafer substrate is formed. Through the through holes TSV1 and TSV2 formed in the second single crystal semiconductor substrate 210, the display layer 230 and the driving unit 100 may be electrically connected to each other through the routing lines RM1 and RM2 without an additional wire.

A process of reducing the thickness of the second single crystal semiconductor substrate 210 may be performed after the driving unit 100 is bonded onto the silicon wafer substrate. The second single crystal semiconductor substrate 210 may have a thickness larger than that of the wafer substrate on which a process for forming conductive layers is performed. In one or more embodiments, the thickness of the second single crystal semiconductor substrate 210 may be 100 µm or less, for example, in the range of 80 µm to 100 µm.

The semiconductor backplane SBP and the pixel circuit backplane EBP may be disposed on the second single crystal semiconductor substrate 210. Some of the pixel circuit backplane EBP and the semiconductor backplane SBP may constitute the second pixel circuit 820 of the display unit 200.

A third semiconductor insulating film SINS3 may be disposed on the second single crystal semiconductor substrate 210. The third semiconductor insulating film SINS3 may be formed of silicon carbonitride (SiCN) and/or a silicon oxide (SiOₓ)-based inorganic film, but is not limited thereto.

A fourth semiconductor insulating film SINS4 may be disposed on the third semiconductor insulating film SINS3. The fourth semiconductor insulating film SINS4 may be formed of a silicon oxide (SiOₓ)-based inorganic film, but is not limited thereto.

Each of the plurality of contact electrodes CTE may be connected to one of the gate electrode GE, the source region SA, and the drain region DA of each of the second transistors PTR2 through holes penetrating the third semiconductor insulating film SINS3 and the fourth semiconductor insulating layer INS4. The plurality of contact electrodes CTE may be formed of copper (Cu), aluminum (Al), tungsten (W), molybdenum (Mo), chromium (Cr), gold (Au), titanium (Ti), nickel (Ni), and/or neodymium (Nd), and/or an alloy including any one of them.

The pixel circuit backplane EBP may include third to seventh interlayer insulating layers INS3, INS4, INS5, INS6, and INS7 and a plurality of connection conductive layers RMT. The connection conductive layer RMT may include wires electrically connected to the plurality of second transistors PTR2 formed on the second single crystal semiconductor substrate 210. The pixel circuit backplane EBP may include the driving voltage lines VSL and VDL disposed in the display unit 200.

The third interlayer insulating layer INS3 may be disposed on the plurality of contact electrodes CTE and the semiconductor insulating layers SINS3 and SINS4. The fourth interlayer insulating layer INS4 may be disposed on the third interlayer insulating layer INS3. The fifth interlayer insulating layer INS5, the sixth interlayer insulating layer INS6, and the seventh interlayer insulating layer INS7 may be disposed sequentially on the fourth interlayer insulating layer INS4. The plurality of connection conductive layers RMT may be disposed between the third interlayer insulating layer INS3 to the seventh interlayer insulating layer INS7. Each of the third to seventh interlayer insulating layers INS3 to INS7 may be formed of silicon carbonitride (SiCN) and/or a silicon oxide (SiOₓ)-based inorganic film, but is not limited thereto. Although it is illustrated in the drawings that each of the third to seventh interlayer insulating layers INS3 to INS7 is formed as a single layer, the present disclosure is not limited thereto. Each of the third to seventh interlayer insulating layers INS3 to INS7 may have a structure in which one or more layers are stacked on top of each other, and may be disposed between the plurality of first to eighth conductive layers ML1 to ML8 to be described later.

The connection conductive layer RMT may have a structure similar to the plurality of conductive layers ML1 to ML8 and the vias VA1 to VA8 of the driving circuit layer 120 (e.g., see FIG. 10). The connection conductive layer RMT may include at least one conductive layer and vias disposed therebetween, and may constitute wires disposed in the display unit 200, such as the driving voltage lines VSL and VDL. For example, the connection conductive layers RMT disposed in the display area DAA may be electrically connected to the second transistor PTR2 to constitute the pixel circuit of FIG. 5. The connection conductive layers RMT may serve as connection lines that connect the second transistor PTR2 to other circuit elements.

The connection wiring layer 500 may be disposed on the bottom surface of the second single crystal semiconductor substrate 210. The connection wiring layer 500 may include an interlayer insulating layer RINS and the plurality of connection lines RML1 and RML2.

The interlayer insulating layer RINS may be disposed on the bottom surface of the second single crystal semiconductor substrate 210. The interlayer insulating layer RINS may be formed of a silicon carbon nitride (SiCN) and/or silicon oxide (SiOₓ)-based inorganic film, but is not limited thereto. In the drawing, the interlayer insulating layer RINS is illustrated as a single layer, but is not limited thereto and may have a structure in which one or more layers are stacked on top of each other, and they may be disposed between the connection lines RML1 and RML2.

The connection lines RML1 and RML2 may form the routing lines RM1 and RM2 together with the conductive vias RVA1 and RVA2. The connection lines RML 1 and RML2 may include one or more conductive layers, and one or more vias connecting them to each other. The connection and structure of the connection lines RML1 and RML2 may be the same as described above for the conductive layers ML1 to ML8 and the vias VA1 to VA8. The connection line RML (e.g., RML1, RML2) may be electrically connected to the second pixel circuit 820 or the circuit board 300 through the conductive vias RVA1 and RVA2 disposed in the through holes TSV1 and TSV2 of the second single crystal semiconductor substrate 210, and may electrically connect each of them to the driving circuit layer 120 of the driving unit 100.

The first conductive via RVA1 of the first routing line RM1 may be disposed in the first through hole TSV1. The first through hole TSV1 may penetrate the second single crystal semiconductor substrate 210, the semiconductor insulating layers SINS3 and SINS4, and the interlayer insulating layers INS3, INS4, and INS5. The first conductive via RVA1 of the first routing line RM1 may be disposed in the first through hole TSV1 from the bottom surface of the sixth interlayer insulating layer INS6 to the bottom surface of the second single crystal semiconductor substrate 210, and may be connected to a first connection line RML1. The first conductive via RVA1 may be connected to the second transistor PTR2 through the connection conductive layer RMT of the pixel circuit backplane EBP, and may be connected to the first pixel circuit 810 of the driving unit 100 through the first connection line RML1. The first connection line RML1 may be a wire illustrated on the rear surface of the display unit 200 in FIG. 9.

The second conductive via RVA2 of the second routing line RM2 may be disposed in the second through hole TSV2. The second through hole TSV2 may penetrate the second single crystal semiconductor substrate 210, the semiconductor insulating layers SINS3 and SINS4, and the interlayer insulating layers INS3, INS4, and INS5. The second conductive via RVA2 of the second routing line RM2 may be disposed in the second through hole TSV2 from the bottom surface of the sixth interlayer insulating layer INS6 to the bottom surface of the second single crystal semiconductor substrate 210, and may be connected to the second connection line RML2. The second conductive via RVA2 may be connected to a write signal terminal GTD of the pixel circuit backplane EBP, and may be connected to the signal terminal STD of the driving unit 100 through the second connection line RML2.

In the display device 10, the circuit units provided in the driving unit 100 may be formed by a high-cost micro semiconductor process, and thus may be formed with a high integration density on the first single crystal semiconductor substrate 110 having a small area. The fabrication process of the driving unit 100 may have a high yield per unit wafer substrate, and a circuit element (e.g., the first transistor) may have a small size, resulting in reduced power consumption. In addition, by dividedly disposing the elements constituting the pixel circuit for light emission of the light emitting element in the driving unit 100 and the display unit 200, an excessive increase in the integration density of the first single crystal semiconductor substrate 110 may be prevented or reduced. Further, the driving voltage lines VSL and VDL to which a voltage for driving the light emitting elements is applied may be disposed in the display unit 200 without passing through the driving unit 100, and a voltage drop may be effectively prevented or reduced by eliminating an unnecessary current path.

The display layer 230 may be disposed on the second single crystal semiconductor substrate 210 and the pixel circuit backplane EBP. The display layer 230 may include the display element layer EML, the encapsulation layer TFE, the adhesive layer ADL, the optical layer OPL, and the cover layer DCL. The display layer 230 may include light emitting elements electrically connected to the driving unit 100 and operable to emit light.

The display element layer EML may be disposed on the pixel circuit backplane EBP. The display element layer EML may include the reflective electrode layer RL, eighth and ninth interlayer insulating layers INS8 and INS9, the electrode via VAP, light emitting elements, the pixel defining film PDL, and the plurality of trenches TRC. The light emitting elements may include the first electrode AND, the light emitting stack IL, and the second electrode CAT.

The reflective electrode layer RL may be disposed on the seventh interlayer insulating layer INS7. The reflective electrode layer RL may include at least one reflective electrode RL1, RL2, RL3, and RL4. For example, the reflective electrode layer RL may include first to fourth reflective electrodes RL1, RL2, RL3, and RL4.

Each of the first reflective electrodes RL1 may be disposed on the seventh interlayer insulating layer INS7 and may be connected to a via penetrating the seventh interlayer insulating layer INS7. The first reflective electrodes RL1 may be formed of copper (Cu), aluminum (Al), tungsten (W), molybdenum (Mo), chromium (Cr), gold (Au), titanium (Ti), nickel (Ni), and/or neodymium (Nd), and/or an alloy including any one or more of them. For example, the first reflective electrodes RL1 may include titanium nitride (TiN).

Each of the second reflective electrodes RL2 may be disposed on the first reflective electrode RL1. The second reflective electrodes RL2 may be formed of copper (Cu), aluminum (Al), tungsten (W), molybdenum (Mo), chromium (Cr), gold (Au), titanium (Ti), nickel (Ni), and/or neodymium (Nd), and/or an alloy including any one or more of them. For example, the second reflective electrodes RL2 may include aluminum (Al).

Each of the third reflective electrodes RL3 may be disposed on the second reflective electrode RL2. The third reflective electrodes RL3 may be formed of copper (Cu), aluminum (Al), tungsten (W), molybdenum (Mo), chromium (Cr), gold (Au), titanium (Ti), nickel (Ni), and/or neodymium (Nd), and/or an alloy including any one or more of them. For example, the third reflective electrodes RL3 may include titanium nitride (TiN).

The fourth reflective electrodes RL4 may be respectively disposed on the third reflective electrodes RL3. The fourth reflective electrodes RL4 may be formed of copper (Cu), aluminum (Al), tungsten (W), molybdenum (Mo), chromium (Cr), gold (Au), titanium (Ti), nickel (Ni), and/or neodymium (Nd), and/or an alloy including any one or more of them. For example, the fourth reflective electrodes RL4 may include titanium (Ti).

Because the second reflective electrode RL2 is an electrode that substantially reflects light from the light emitting elements, the thickness of the second reflective electrode RL2 may be greater than the thickness of each of the first reflective electrode RL1, the third reflective electrode RL3, and the fourth reflective electrode RL4. For example, the thickness of each of the first reflective electrode RL1, the third reflective electrode RL3, and the fourth reflective electrode RL4 may be approximately 100 Å, and the thickness of the second reflective electrode RL2 may be 850 Å. However, in one or more embodiments, the thickness of the second reflective electrode RL2 may be substantially the same as the thickness of each of the first reflective electrode RL1, the third reflective electrode RL3, and the fourth reflective electrode RL4.

The eighth interlayer insulating layer INS8 may be disposed on the seventh interlayer insulating layer INS7. The eighth interlayer insulating layer INS8 may be disposed between the reflective electrode layers RL adjacent to each other. The eighth interlayer insulating layer INS8 may be disposed on the reflective electrode layer RL in the first sub-pixel SP1. The eighth interlayer insulating layer INS8 may be formed of a silicon oxide (SiOₓ)-based inorganic film, but is not limited thereto.

The ninth interlayer insulating layer INS9 may be disposed on the eighth interlayer insulating layer INS8 and the reflective electrode layer RL. The ninth interlayer insulating layer INS9 may be formed of a silicon oxide (SiOₓ)-based inorganic film, but is not limited thereto.

In at least one of the first sub-pixel SP1, the second sub-pixel SP2, or the third sub-pixel SP3, the eighth interlayer insulating layer INS8 and the ninth interlayer insulating layer INS9 may not be disposed under the first electrode AND in consideration of the resonance distance of the light emitted from the light emitting elements LE.

For example, the first electrode AND of the third sub-pixel SP3 may be directly disposed on the fourth reflective electrode RL4, and the first electrode AND of the third sub-pixel SP3 may not overlap the eighth interlayer insulating layer INS8 and the ninth interlayer insulating layer INS9. The first electrode AND of the second sub-pixel SP2 may be disposed on the ninth interlayer insulating layer INS9, and the ninth interlayer insulating layer INS9 may be directly disposed on the fourth reflective electrode RL4. That is, the first electrode AND of the second sub-pixel SP2 may not overlap the eighth interlayer insulating layer INS8. The first electrode AND of the first sub-pixel SP1 may be disposed on the ninth interlayer insulating layer INS9, and may overlap the eighth interlayer insulating layer INS8.

In one or more embodiments, the distance between the first electrode AND and the reflective electrode layer RL may be different in the first sub-pixel SP1, the second sub-pixel SP2, and the third sub-pixel SP3. In order to adjust the distance from the reflective electrode layer RL to the second electrode CAT according to the main wavelength of the light emitted from each of the first sub-pixel SP1, the second sub-pixel SP2, and the third sub-pixel SP3, the presence or absence of the eighth interlayer insulating layer INS8 and the ninth interlayer insulating layer INS9 may be set in each of the first sub-pixel SP1, the second sub-pixel SP2, and the third sub-pixel SP3. For example, in FIG. 13, the distance between the first electrode AND and the reflective electrode layer RL in the first sub-pixel SP1 may be larger than the distance between the first electrode AND and the reflective electrode layer RL in the second sub-pixel SP2 and the distance between the first electrode AND and the reflective electrode layer RL in the third sub-pixel SP3, and the distance between the first electrode AND and the reflective electrode layer RL in the second sub-pixel SP2 may be larger than the distance between the first electrode AND and the reflective electrode layer RL in the third sub-pixel SP3. However, the present disclosure is not limited thereto. The distance between the first electrode AND and the reflective electrode layer RL in each of the sub-pixels SP1, SP2, and SP3 may be variously modified and designed.

In addition, although the eighth interlayer insulating layer INS8 and the ninth interlayer insulating layer INS9 are illustrated in the drawing, a tenth interlayer insulating layer may be further disposed under the first electrode AND of the sub-pixel SP. In this case, the ninth interlayer insulating layer INS9 and the tenth interlayer insulating layer may be disposed under the first electrode AND of the second sub-pixel SP2, and the eighth interlayer insulating layer INS8, the ninth interlayer insulating layer INS9, and the tenth interlayer insulating layer may be disposed under the first electrode AND of the first sub-pixel SP1.

Each of the electrode vias VAP may be connected to the fourth reflective electrode RL4 exposed through the eighth interlayer insulating layer INS8 and/or the ninth interlayer insulating layer INS9 in the first sub-pixel SP1 and the second sub-pixel SP2. The electrode vias VAP may be formed of copper (Cu), aluminum (Al), tungsten (W), molybdenum (Mo), chromium (Cr), gold (Au), titanium (Ti), nickel (Ni), and/or neodymium (Nd), or an alloy including any one or more of them. The thickness of the electrode via VAP in the second sub-pixel SP2 may be smaller than the thickness of the electrode via VAP in the first sub-pixel SP1.

The first electrode AND of each of the light emitting elements is disposed on the ninth interlayer insulating layer INS9 or the reflective electrode layer RL and may be connected to the electrode via VAP. The first electrode AND of each of the light emitting elements LE may be connected to the second transistor PTR2 through the electrode via VAP, the first to fourth reflective electrodes RL1 to RL4, the connection conductive layer RMT, and the contact electrode CTE. The first electrode AND of each of the light emitting elements may be formed of copper (Cu), aluminum (Al), tungsten (W), molybdenum (Mo), chromium (Cr), gold (Au), titanium (Ti), nickel (Ni), and/or neodymium (Nd), and/or an alloy including any two or more of them. For example, the first electrode AND of each of the light emitting elements may be titanium nitride (TiN).

The pixel defining film PDL may be disposed on a portion of the first electrode AND of each of the light emitting elements. The pixel defining film PDL may cover the edge of the first electrode AND of each of the light emitting elements. The pixel defining film PDL may serve to partition the first emission areas EA1, the second emission areas EA2, and the third emission areas EA3.

The first emission area EA1 may be defined as an area in which the first electrode AND, the light emitting stack IL, and the second electrode CAT are sequentially stacked in the first sub-pixel SP1 to emit light. The second emission area EA2 may be defined as an area in which the first electrode AND, the light emitting stack IL, and the second electrode CAT are sequentially stacked in the second sub-pixel SP2 to emit light. The third emission area EA3 may be defined as an area in which the first electrode AND, the light emitting stack IL, and the second electrode CAT are sequentially stacked in the third sub-pixel SP3 to emit light.

The pixel defining film PDL may include first to third pixel defining films PDL1, PDL2, and PDL3. The first pixel defining film PDL1 may be disposed on the edge of the first electrode AND of each of the light emitting elements LE, the second pixel defining film PDL2 may be disposed on the first pixel defining film PDL1, and the third pixel defining film PDL3 may be disposed on the second pixel defining film PDL2. The first pixel defining film PDL1, the second pixel defining film PDL2, and the third pixel defining film PDL3 may be formed of a silicon oxide (SiOₓ)-based inorganic film, but are not limited thereto. The first pixel defining film PDL1, the second pixel defining film PDL2, and the third pixel defining film PDL3 may each have a thickness of about 500 Å.

When the first pixel defining film PDL1, the second pixel defining film PDL2, and the third pixel defining film PDL3 are formed as one pixel defining film, the height of the one pixel defining film increases, so that a first inorganic encapsulation layer TFE1 may be cut off due to step coverage. Step coverage refers to the ratio of the degree of thin film coated on an inclined portion to the degree of thin film coated on a flat portion. The lower the step coverage, the more likely it is that the thin film will be cut off at inclined portions.

In order to prevent the first inorganic encapsulation layer TFE1 from being cut off due to the step coverage, the first pixel defining film PDL1, the second pixel defining film PDL2, and the third pixel defining film PDL3 may have a cross-sectional structure having a stepped portion. For example, the width of the first pixel defining film PDL1 may be greater than the width of the second pixel defining film PDL2 and the width of the third pixel defining film PDL3, and the width of the second pixel defining film PDL2 may be greater than the width of the third pixel defining film PDL3. The width of the first pixel defining film PDL1 refers to the horizontal length of the first pixel defining film PDL1 defined in the first direction DR1 and the second direction DR2.

Each of the plurality of trenches TRC may penetrate the first pixel defining film PDL1, the second pixel defining film PDL2, and the third pixel defining film PDL3. In each of the plurality of trenches TRC, a portion of the eighth interlayer insulating layer INS8 may be dug and the ninth interlayer insulating layer INS9 may be penetrated.

At least one trench TRC may be disposed between adjacent sub-pixels SP1, SP2, and SP3. It is illustrated in the drawing that two trenches TRC are disposed between the adjacent sub-pixels SP1, SP2, and SP3, but the present disclosure is not limited thereto.

The light emitting stack IL may include a plurality of stacks. It is illustrated in the drawing that the light emitting stack IL has a three-tandem structure including a first light emitting stack IL1, a second light emitting stack IL2, and a third light emitting stack IL3, but the present disclosure is not limited thereto. For example, the light emitting stack IL may have a two-tandem structure including two light emitting stacks.

In the three-tandem structure, the light emitting stack IL may have a tandem structure including the plurality of light emitting stacks IL1, IL2, and IL3 that emit different lights. For example, the light emitting stack IL may include the first light emitting stack IL1 that emits first light, the second light emitting stack IL2 that emits third light, and the third light emitting stack IL3 that emits second light. The first light emitting stack IL1, the second light emitting stack IL2, and the third light emitting stack IL3 may be sequentially stacked.

The first light emitting stack IL1 may have a structure in which a first hole transport layer, a first organic light emitting layer that emits first light, and a first electron transport layer are sequentially stacked. The second light emitting stack IL2 may have a structure in which a second hole transport layer, a second organic light emitting layer that emits third light, and a second electron transport layer are sequentially stacked. The third light emitting stack IL3 may have a structure in which a third hole transport layer, a third organic light emitting layer that emits second light, and a third electron transport layer are sequentially stacked.

A first charge generation layer for supplying charges to the second light emitting stack IL2 and supplying electrons to the first light emitting stack IL1 may be disposed between the first light emitting stack IL1 and the second light emitting stack IL2. The first charge generation layer may include an N-type charge generation layer that supplies electrons to the first light emitting stack IL1 and a P-type charge generation layer that supplies holes to the second light emitting stack IL2. The N-type charge generation layer may include a dopant of a metal material.

A first charge generation layer for supplying charges to the third light emitting stack IL3 and supplying electrons to the second light emitting stack IL2 may be disposed between the second light emitting stack IL2, and the third light emitting stack IL3. The second charge generation layer may include an N-type charge generation layer that supplies electrons to the second light emitting stack IL2 and a P-type charge generation layer that supplies holes to the third light emitting stack IL3.

The first light emitting stack IL1 may be disposed on the first electrodes AND and the pixel defining film PDL, and may be disposed on the bottom surface of each trench TRC. Due to the trench TRC, the first light emitting stack IL1 may be cut off between adjacent sub-pixels SP1, SP2, and SP3. The second light emitting stack IL2 may be disposed on the first light emitting stack IL1. Due to the trench TRC, the second light emitting stack IL2 may be cut off between adjacent sub-pixels SP1, SP2, and SP3. A void or an empty space may be disposed between the first light emitting stack IL1 and the second light emitting stack IL2. The third light emitting stack IL3 may be disposed on the second light emitting stack IL2. The third light emitting stack IL3 is not cut off by the trench TRC and may be disposed to cover the second light emitting stack IL2 in each of the trenches TRC. That is, in the three-tandem structure, each of the plurality of trenches TRC may be a structure for cutting off the first to second light emitting stacks IL1 and IL2, the first charge generation layer, and the second charge generation layer of the display element layer EML between the sub-pixels SP1, SP2, and SP3 adjacent to each other. In addition, in the two-tandem structure, each of the plurality of trenches TRC may be a structure for cutting off the charge generation layer and a lower light emitting stack disposed between the lower light emitting stack and an upper light emitting stack.

In order to stably cut off the first and second light emitting stacks IL1 and IL2 of the display element layer EML between adjacent sub-pixels SP1, SP2, and SP3, the height of each of the plurality of trenches TRC may be greater than the height of the pixel defining film PDL. The height of each of the plurality of trenches TRC refers to the length of each of the plurality of trenches TRC in the third direction DR3. The height of the pixel defining film PDL refers to the length of the pixel defining film PDL in the third direction DR3. In order to cut off the first to third light emitting stacks IL1, IL2, and IL3 of the display element layer EML between the neighboring sub-pixels SP1, SP2, and SP3, another structure may exist instead of the trench TRC. For example, instead of the trench TRC, a reverse tapered partition wall may be disposed on the pixel defining film PDL.

The number of the light emitting stacks IL1, IL2, and IL3 that emit different lights is not limited to that shown in the drawing. For example, the light emitting stack IL may include two light emitting stacks. In this case, one of the two light emitting stacks may be substantially the same as the first light emitting stack IL1, and the other may include a second hole transport layer, a second organic light emitting layer, a third organic light emitting layer, and a second electron transport layer. In this case, a charge generation layer for supplying electrons to one light emitting stack and supplying charges to the other light emitting stack may be disposed between the two light emitting stacks.

In addition, it is illustrated in the drawing that the first to third light emitting stacks IL1, IL2, and IL3 are all disposed in the first emission area EA1, the second emission area EA2, and the third emission area EA3, but the present disclosure is not limited thereto. For example, the first light emitting stack IL1 may be disposed in the first emission area EA1, and may not be disposed in the second emission area EA2 and the third emission area EA3. Furthermore, the second light emitting stack IL2 may be disposed in the second emission area EA2 and may not be disposed in the first emission area EA1 and the third emission area EA3. Further, the third light emitting stack IL3 may be disposed in the third emission area EA3 and may not be disposed in the first emission area EA1 and the second emission area EA2. In this case, first to third color filters CF1, CF2, and CF3 of the optical layer OPL may be omitted.

The second electrode CAT may be disposed on the third light emitting stack IL3. The second electrode CAT may be disposed on the third light emitting stack IL3 in each of the plurality of trenches TRC. The second electrode CAT may be formed of a transparent conductive material (TCO) such as ITO and/or IZO that can transmit light or a semi-transmissive conductive material such as magnesium (Mg), silver (Ag), and/or an alloy of Mg and Ag. When the second electrode CAT is formed of a semi-transmissive conductive material, the light emission efficiency may be improved in each of the first to third sub-pixels SP1, SP2, and SP3 due to a micro-cavity effect. The second electrode CAT may be electrically connected to the first driving voltage line VSL in the common electrode contact area CTA of the non-display area NA.

The encapsulation layer TFE may be disposed on the display element layer EML. The encapsulation layer TFE may include at least one inorganic encapsulation layer TFE1 and TFE3 to prevent oxygen and/or moisture from permeating into the display element layer EML. In addition, the encapsulation layer TFE may include at least one organic film to protect the display element layer EML from foreign substances such as dust. For example, the encapsulation layer TFE may include the first inorganic encapsulation layer TFE1, an organic encapsulation layer TFE2, and a second inorganic encapsulation layer TFE3.

The first inorganic encapsulation layer TFE1 may be disposed on the second electrode CAT, the organic encapsulation layer TFE2 may be disposed on the first inorganic encapsulation layer TFE1, and the second inorganic encapsulation layer TFE3 may be disposed on the organic encapsulation layer TFE2. The first inorganic encapsulation layer TFE1 and the second inorganic encapsulation layer TFE3 may be formed of multiple films in which one or more inorganic films of silicon nitride (SiNₓ), silicon oxynitride (SiOₓN_{y}), silicon oxide (SiOₓ), titanium oxide (TiOₓ), and/or aluminum oxide (AlOₓ) layers are alternately stacked. The organic encapsulation layer TFE2 may be a monomer. Alternatively, the organic encapsulation layer TFE2 may be an organic film such as acryl resin, epoxy resin, phenolic resin, polyamide resin, polyimide resin, and/or the like.

The adhesive layer ADL may be disposed on the encapsulation layer TFE. The adhesive layer ADL may be a layer for bonding the encapsulation layer TFE to a layer disposed thereon. The adhesive layer ADL may be a double-sided adhesive member. In addition, the adhesive layer ADL may be a transparent adhesive member such as a transparent adhesive and/or a transparent adhesive resin.

The optical layer OPL may include the color filter layer CFL, the plurality of lenses LNS, and a filling layer FIL. The color filter layer CFL may include the first to third color filters CF1, CF2, and CF3. The first to third color filters CF1, CF2, and CF3 may be disposed on the adhesive layer ADL.

The first color filter CF1 may overlap the first emission area EA1. The first color filter CF1 may transmit first light, i.e., light of a red wavelength band. The red wavelength band may be approximately 600 nm to 750 nm. The first color filter CF1 may transmit first light from among light emitted from the first emission area EA1.

The second color filter CF2 may overlap the second emission area EA2. The second color filter CF2 may transmit second light, i.e., light of a green wavelength band. The green wavelength band may be approximately 480 nm to 560 nm. The second color filter CF2 may transmit second light from among light emitted from the second emission area EA2.

The third color filter CF3 may overlap the third emission area EA3. The third color filter CF3 may transmit third light, i.e., light of a blue wavelength band. The blue wavelength band may be approximately 370 nm to 460 nm. The third color filter CF3 may transmit third light from among light emitted from the third emission area EA3.

The plurality of lenses LNS may be disposed on the first color filter CF1, the second color filter CF2, and the third color filter CF3, respectively. Each of the plurality of lenses LNS may be a structure for increasing a ratio of light directed to the front of the display device 10. Each of the plurality of lenses LNS may have a cross-sectional shape that is convex in an upward direction.

The filling layer FIL may be disposed on the plurality of lenses LNS. The filling layer FIL may have a suitable refractive index (e.g., a predetermined refractive index) such that light travels in the third direction DR3 at an interface between the filling layer FIL and the plurality of lenses LNS. Further, the filling layer FIL may be a planarization layer. The filling layer FIL may be an organic film such as acrylic resin, epoxy resin, phenolic resin, polyamide resin, and/or polyimide resin.

The cover layer DCL may be disposed on the filling layer FIL. The cover layer DCL may be a glass substrate and/or a polymer resin. When the cover layer DCL is a glass substrate, it may be attached onto the filling layer FIL. In this case, the filling layer FIL may serve to bond the cover layer DCL. When the cover layer DCL is a glass substrate, it may serve as an encapsulation substrate. When the cover layer DCL is a polymer resin, it may be directly applied onto the filling layer FIL.

In one or more embodiments, the display unit 200 may further include a polarizing plate disposed on the cover layer DCL. The polarizing plate may be disposed on one surface of the cover layer DCL. The polarizing plate may be a structure for preventing visibility degradation caused by reflection of external light. The polarizing plate may include a linear polarizing plate and a phase retardation film. For example, the phase retardation film may be a λ/4 plate (quarter-wave plate), but is not limited thereto. However, when visibility degradation caused by reflection of external light is sufficiently overcome by the first to third color filters CF1, CF2, and CF3, the polarizing plate may be omitted.

Hereinafter, various embodiments of the display device 10 will be described with reference to other drawings.

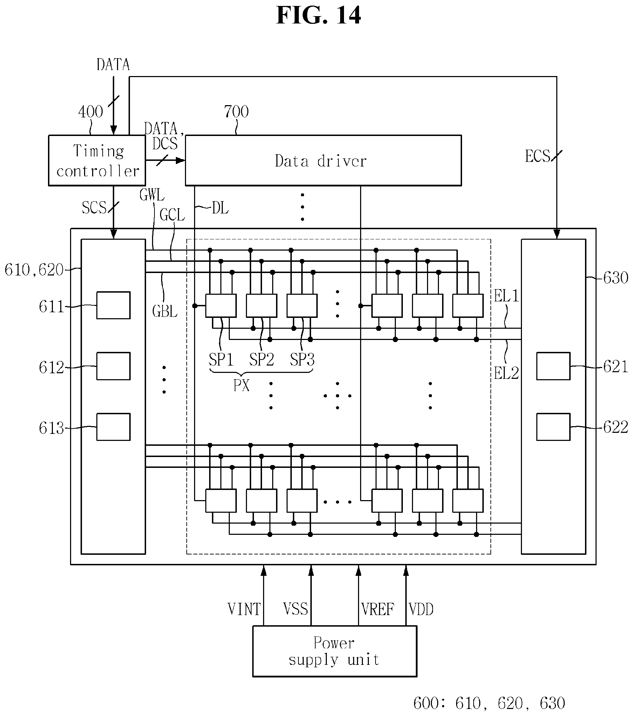

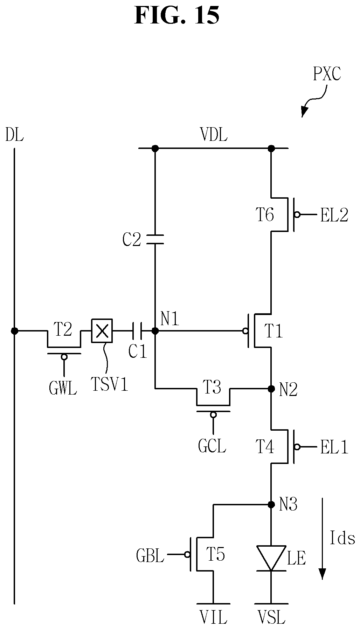

FIG. 14 is a block diagram showing an example of a display device according to one or more embodiments. FIG. 15 is an equivalent circuit diagram of one pixel of the display device of FIG. 14.

Referring to FIGS. 14 and 15, in the display device 10 according to one or more embodiments, the pixel circuits PXC of the respective sub-pixel SP1, SP2, and SP3 may include a larger number of transistors T1 to T6. Accordingly, the display device 10 may include an additional gate driver and signal lines disposed in the display unit 200.

When describing the block diagram of the display device 10 with reference to FIG. 14, the driving circuit 400 may include a timing control circuit (i.e. a timing controller). In addition, the driving circuit 400 may further include various circuits involved in driving the display device 10, such as a gamma circuit and a logic circuit. The driving circuit 400 may include driving circuit transistors formed on the first single crystal semiconductor substrate 110.

The driving circuit 400 may receive digital video data DATA and timing signals from the outside. The timing control circuit may generate the scan timing control signal SCS, an emission timing control signal ECS, and the data timing control signal DCS for controlling the display unit 200 according to the timing signals. The timing control circuit may output the scan timing control signal SCS to a first scan driver 610 and a second scan driver 620 of the gate driver 600, and may output the emission timing control signal ECS to an emission driver 630 of the gate driver 600. The timing control circuit may output the digital video data DATA and the data timing control signal DCS to the data driver 700.

A power supply unit may generate a plurality of panel driving voltages by an external power voltage. For example, the power supply unit may generate the first driving voltage VSS, the second driving voltage VDD, a reference voltage VREF, and an initialization voltage VINT and supply them to the plurality of pixels PX.

The scan timing control signal SCS, the emission timing control signal ECS, the digital video data DATA, and the data timing control signal DCS of the driving circuit 400 may be supplied to the plurality of pixels PX. The first driving voltage VSS, the second driving voltage VDD, the reference voltage VREF, and the initialization voltage VINT of the power supply unit may also be supplied to the plurality of pixels PX.

The gate driver 600 may include the first scan driver 610 and the second scan driver 620, and the emission driver 630. The first scan driver 610 may include a plurality of scan transistors formed on the first single crystal semiconductor substrate 110, the second scan driver 620 may include scan transistors formed on the second single crystal semiconductor substrate 210, and the emission driver 630 may include a plurality of emission transistors formed on the second single crystal semiconductor substrate 210. The plurality of scan transistors and the plurality of emission transistors may be formed through a semiconductor process. For example, the plurality of scan transistors and the plurality of emission transistors may be formed as CMOS transistors.

The first scan driver 610 may include a first scan signal output unit 611, and the second scan driver 620 may include a second scan signal output unit 612 and a third scan signal output unit 613. Each of the first scan signal output unit 611, the second scan signal output unit 612, and the third scan signal output unit 613 may receive the scan timing control signal SCS from the driving circuit 400. The first scan signal output unit 611 may generate write scan signals according to the scan timing control signal SCS of the driving circuit 400 and output them sequentially to first scan lines GWL. The second scan signal output unit 612 may generate control scan signals in response to the scan timing control signal SCS and sequentially output them to the second scan lines GCL. The third scan signal output unit 613 may generate bias scan signals according to the scan timing control signal SCS and output them sequentially to third scan lines GBL.

The emission driver 630 may include a first emission signal output unit 621 and a second emission signal output unit 622. Each of the first emission signal output unit 621 and the second emission signal output unit 622 may receive the emission timing control signal ECS from the driving circuit 400. The emission driver 630 may generate emission control signals according to the emission timing control signal ECS and sequentially output them to the first and second emission control lines EL1 and EL2.

The data driver 700 may receive the digital video data DATA and the data timing control signal DCS from the driving circuit 400. The data driver 700 converts the digital video data DATA into analog data voltages according to the data timing control signal DCS and outputs the analog data voltages to the data lines DL. In this case, the sub-pixels SP1, SP2, and SP3 are selected by the write scan signal of the scan driver 610, and data voltages may be supplied to the selected sub-pixels SP1, SP2, and SP3.

When describing the pixel circuit PXC with reference to FIG. 15, the pixel circuit PXC may be connected to the first scan line GWL, the second scan line GCL, the third scan line GBL, the first emission control line EL1, the second emission control line EL2, and the data line DL. In addition, the pixel circuit PXC may be connected to the first driving voltage line VSL to which the first driving voltage VSS corresponding to a low potential voltage is applied, the second driving voltage line VDL to which the second driving voltage VDD corresponding to a high potential voltage is applied, and a third driving voltage line VIL to which the initialization voltage or a third driving voltage VINT is applied. That is, the first driving voltage line VSL may be a low potential voltage line, the second driving voltage line VDL may be a high potential voltage line, and the third driving voltage line VIL may be an initialization voltage line. In this case, the first driving voltage VSS may be lower than the third driving voltage VINT. The second driving voltage VDD may be higher than the third driving voltage VINT.

The pixel circuit PXC includes the plurality of transistors T1 to T6, the light emitting element LE, the first capacitor C1, and a second capacitor C2.

The light emitting element LE emits light in response to the driving current Ids flowing through the channel of the first transistor T1. The emission amount of the light emitting element LE may be proportional to the driving current Ids. The light emitting element LE may be disposed between a fourth transistor T4 and the first driving voltage line VSL. The first electrode of the light emitting element LE may be connected to the drain electrode of the fourth transistor T4, and the second electrode thereof may be connected to the first driving voltage line VSL. The first electrode of the light emitting element LE may be an anode electrode, and the second electrode of the light emitting element LE may be a cathode electrode.

The first transistor T1 may be a driving transistor that controls the source-drain current Ids (hereinafter referred to as "driving current") flowing between the source electrode and the drain electrode thereof according to a voltage applied to the gate electrode thereof. The first transistor T1 includes a gate electrode connected to the first node N1, a source electrode connected to the drain electrode of a sixth transistor T6, and a drain electrode connected to a second node N2.

The second transistor T2 may be disposed between one electrode of the first capacitor C1 and the data line DL. The second transistor T2 is turned on by the write scan signal of the first scan line GWL to connect the one electrode of the first capacitor C1 to the data line DL. Accordingly, the data voltage of the data line DL may be applied to the one electrode of the first capacitor C1. The second transistor T2 includes a gate electrode connected to the first scan line GWL, a source electrode connected to the data line DL, and a drain electrode connected to the one electrode of the first capacitor C1.

A third transistor T3 may be disposed between the first node N1 and the second node N2. The third transistor T3 is turned on by the control scan signal of the second scan line GCL to connect the first node N1 to the second node N2. For this reason, because the gate electrode and the source electrode of the first transistor T1 are connected, the first transistor T1 may operate like a diode (e.g., the first transistor T1 may be diode-connected). The third transistor T3 includes a gate electrode connected to the second scan line GCL, a source electrode connected to the second node N2, and a drain electrode connected to the first node N1.

The fourth transistor T4 may be connected between the second node N2 and a third node N3. The fourth transistor T4 is turned on by the first emission control signal of the first emission control line EL1 to connect the second node N2 to the third node N3. Accordingly, the driving current of the first transistor T1 may be supplied to the light emitting element LE. The fourth transistor T4 includes a gate electrode connected to the first emission control line EL1, a source electrode connected to the second node N2, and a drain electrode connected to the third node N3.

A fifth transistor T5 may be disposed between the third node N3 and the third driving voltage line VIL. The fifth transistor T5 is turned on by the bias scan signal of the third scan line GBL to connect the third node N3 to the third driving voltage line VIL. Accordingly, the third driving voltage VINT of the third driving voltage line VIL may be applied to the first electrode of the light emitting element LE. The fifth transistor T5 includes a gate electrode connected to the third scan line GBL, a source electrode connected to the third node N3, and a drain electrode connected to the third driving voltage line VIL.

The sixth transistor T6 may be disposed between the source electrode of the first transistor T1 and the second driving voltage line VDL. The sixth transistor T6 is turned on by the second emission control signal of the second emission control line EL2 to connect the source electrode of the first transistor T1 to the second driving voltage line VDL. Accordingly, the second driving voltage VDD of the second driving voltage line VDL may be applied to the source electrode of the first transistor T1. The sixth transistor T6 includes a gate electrode connected to the second emission control line EL2, a source electrode connected to the second driving voltage line VDL, and a drain electrode connected to the source electrode of the first transistor T1.

The first capacitor C1 is formed between the first node N1 and the drain electrode of the second transistor T2. The first capacitor C1 includes one electrode connected to the drain electrode of the second transistor T2 (via first through hole TSV1) and the other electrode connected to the first node N1.

The second capacitor C2 is formed between the gate electrode of the first transistor T1 (or the first node N1) and the second driving voltage line VDL. The second capacitor C2 includes one electrode connected to the gate electrode of the first transistor T1 (or the first node N1) and the other electrode connected to the second driving voltage line VDL.

The first node N1 is a junction between the gate electrode of the first transistor T1, the drain electrode of the third transistor T3, the other electrode of the first capacitor C1, and the one electrode of the second capacitor C2. The second node N2 is a junction between the drain electrode of the first transistor T1, the source electrode of the third transistor T3, and the source electrode of the fourth transistor T4. The third node N3 is a junction between the drain electrode of the fourth transistor T4, the source electrode of the fifth transistor T5, and the first electrode of the light emitting element LE.

According to one or more embodiments, in the display device 10, the second transistor T2 may be formed on the first single crystal semiconductor substrate 110 of the driving unit 100, and the first transistor T1, and the third to sixth transistors T3 to T6 may be formed on the second single crystal semiconductor substrate 210 of the display unit 200. The second transistor T2 may be connected to one electrode of the first capacitor C1 through the first through hole TSV1 formed on the second single crystal semiconductor substrate 210. Accordingly, the data line DL and the first scan line GWL may be disposed in the first pixel circuit 810 of the driving unit 100, and the second scan line GCL, the third scan line GBL, the emission control lines EL1 and EL2, and the driving voltage lines VSL, VDL, and VIL may be disposed in the second pixel circuit 820 of the display unit 200.

Each of the first to sixth transistors T1 to T6 may be a metal-oxide-semiconductor field effect transistor (MOSFET). For example, each of the first to sixth transistors T1 to T6 may be a P-type MOSFET, but is not limited thereto. Each of the first to sixth transistors T1 to T6 may be an N-type MOSFET. Alternatively, some of the first to sixth transistors T1 to T6 may be P-type MOSFETs, and each of the remaining transistors may be an N-type MOSFET.

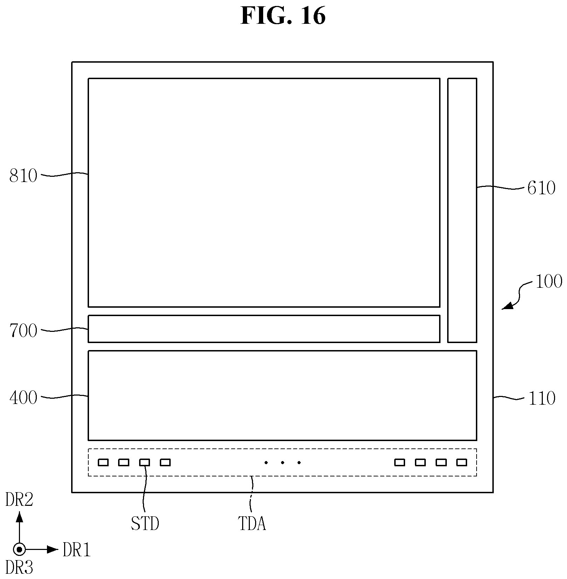

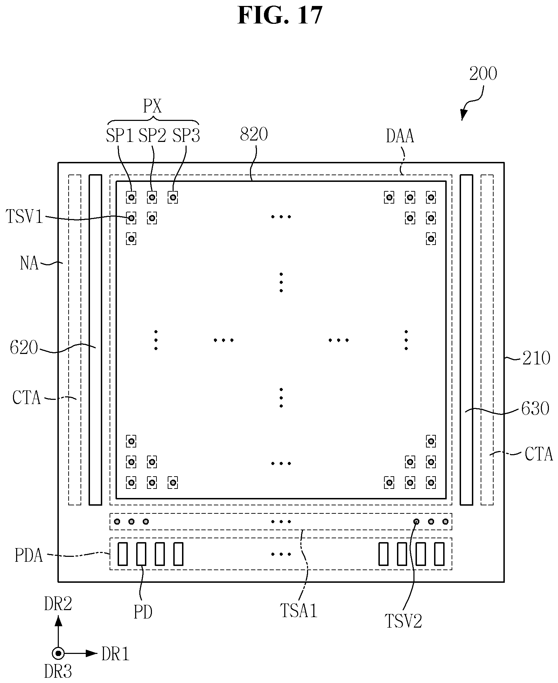

FIG. 16 is a plan view showing an example of a driving unit of the display device of FIGS. 14 and 15. FIG. 17 is a plan view showing an example of a display unit of the display device of FIGS. 14 and 15.

Referring to FIGS. 16 and 17, the driving unit 100 of the display device 10 according to one or more embodiments may include the first single crystal semiconductor substrate 110, and the driving circuit 400, the first scan driver 610, the data driver 700, and the first pixel circuit 810 that are formed on the first single crystal semiconductor substrate 110. The description of the respective components of the driving unit 100 is similar to that described above with reference to FIGS. 2 and 3, so that some redundant descriptions will be omitted below.

The first single crystal semiconductor substrate 110 may be a silicon substrate, a germanium substrate, and/or a silicon-germanium substrate. A plurality of first transistors may be formed on the first single crystal semiconductor substrate 110. The plurality of first transistors may be electrically connected to each other and constitute the driving circuit 400, the gate driver 600, the data driver 700, and the first pixel circuit 810.

The drawing illustrates that the first pixel circuit 810 is disposed on the upper side of the driving unit 100, the data driver 700, the driving circuit 400, and a signal terminal area TDA are disposed below the first pixel circuit 810, and the first scan driver 610 is disposed on the right side of the first pixel circuit 810, which is one side of the first direction DR1. However, the present disclosure is not limited thereto. The first pixel circuit 810 may include the plurality of first transistors, and the plurality of first scan lines GWL and data lines DL electrically connected to the first transistor.

The display unit 200 may include the second single crystal semiconductor substrate 210, the second pixel circuit 820, the second scan driver 620, and the emission driver 630. The display unit 200 may include the display area DAA where the plurality of pixels PX are disposed and the non-display area NA around (e.g., surrounding) the display area DAA. The display unit 200 may include the second scan driver 620, the emission driver 630, the first through hole area TSA1, the pad area PDA, and the common electrode contact area CTA that are disposed in the non-display area NA.

The second scan driver 620 and the emission driver 630 may be disposed in the non-display area NA on the left side and the right side of the display area DAA, respectively, which are both sides in the first direction DR1. The common electrode contact area CTA may be disposed in the non-display area NA on the outermost side of the display area DAA in the first direction DR1, and the second scan driver 620 and the emission driver 630 may be disposed between the common electrode contact area CTA and the display area DAA.

The second single crystal semiconductor substrate 210 may be a silicon substrate, a germanium substrate, and/or a silicon-germanium substrate. A plurality of second transistors may be formed on the second single crystal semiconductor substrate 210, and the plurality of second transistors may be electrically connected to each other to form the pixel circuit for light emission of the plurality of pixels PX. Further, some of the second transistors may form the scan transistor of the second scan driver 620 and the emission transistor of the emission driver 630. The second transistors may be formed through a semiconductor process. For example, the plurality of transistors may be formed as complementary metal oxide semiconductor (CMOS) transistors.

The second pixel circuit 820 may include a plurality of second transistors formed on the second single crystal semiconductor substrate 210. Further, the second pixel circuit 820 may include the second scan line GCL and the third scan line GBL connected to the second scan driver 620, and the emission control lines EL1 and EL2 connected to the emission driver 630. The second pixel circuit 820 may include the plurality of driving voltage lines VDL, VSL, and VIL.

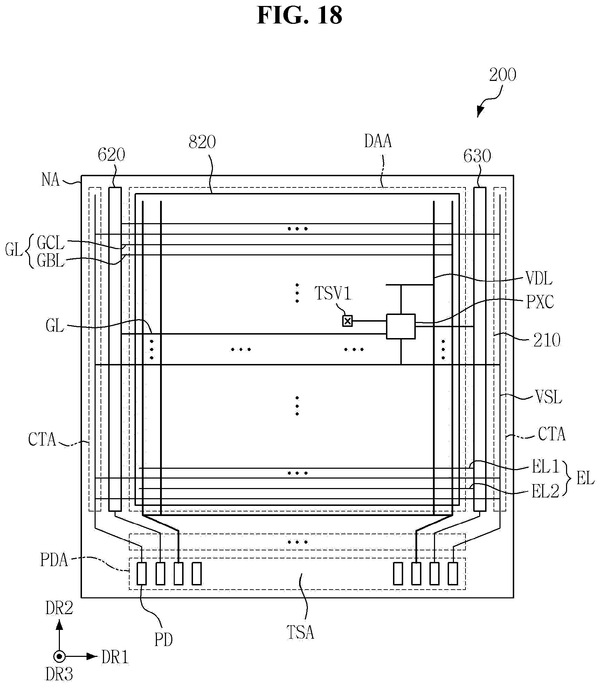

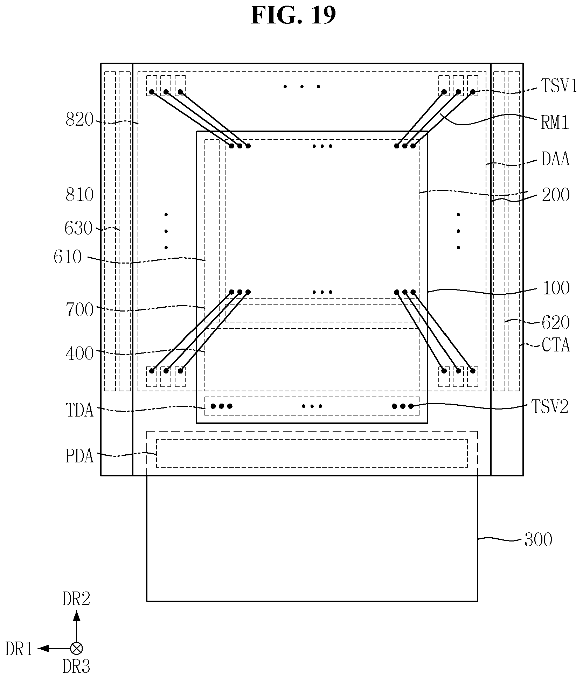

FIG. 18 is a plan view showing the disposition of a plurality of wires disposed in the display unit of FIG. 17. FIG. 19 is a schematic diagram showing a rear surface of the display device of FIGS. 16 and 17.

Referring to FIGS. 18 and 19, the display unit 200 may include the plurality of second scan lines GCL and third scan lines GBL connected to the second scan driver 620. The second scan line GCL and the third scan line GBL may each extend in the first direction DR1, and may be spaced (e.g., spaced apart) from each other in the second direction DR2. The display unit 200 may include the plurality of emission control line EL (EL1 and EL2) connected to the emission driver 630. The first emission control line EL1 and the second emission control line EL2 may each extend in the first direction DR1, and may be spaced (e.g., spaced apart) from each other in the second direction DR2. Further, in one or more embodiments, the display unit 200 may further include the third driving voltage line VIL disposed in the display area DAA. The third driving voltage line VIL may have a line shape extending in the first direction DR1 and the second direction DR2, similarly to the first driving voltage line VDL.

The display unit 200 is different from the embodiment of FIG. 6 in that it further includes the second scan driver 620 and the emission driver 630, the signal lines GL including the second scan line GCL and the third scan line GBL, the emission control lines EL, and the third driving voltage line VIL.

Because the pixel circuit PXC of the display device 10 includes a larger number of transistors T1 to T6, the display device 10 may include a larger number of signal lines and driving voltage lines. In the display device 10, the elements constituting the pixel circuit PXC may be dividedly disposed in the driving unit 100 and the display unit 200 including the different single crystal semiconductor substrates 110 and 210. For example, the second transistor T2 of the pixel circuit PXC may be disposed in the driving unit 100, and the first transistor T1, the third to sixth transistors T3 to T6, and the light emitting element LE may be disposed in the display unit 200. The second transistor T2 may be electrically connected to other transistors through the first through hole TSV1. Due to the disposition of the transistors, the first scan driver 610 and the data driver 700 may be disposed in the driving unit 100, and the second scan driver 620 and the emission driver 630 may be disposed in the display unit 200. Further, the first scan line GWL and the data line DL may be disposed in the driving unit 100, and the second scan line GCL, the third scan line GBL, the emission control lines EL1 and EL2, and the driving voltage lines VSL, VDL, and VIL may be disposed in the display unit 200.

In the display device 10 according to one or more embodiments, even if the pixel circuit PXC for driving the light emitting element LE includes a large number of transistors, the difficulty of layout design due to high integration density may be solved by dividedly disposing them on the different single crystal semiconductor substrates 110 and 210. Further, a sufficient line width may be secured by disposing the driving voltage lines VSL, VDL, and VIL in the display unit 200 having a relatively large area, and a voltage drop may be efficiently prevented by eliminating an unnecessary current path.

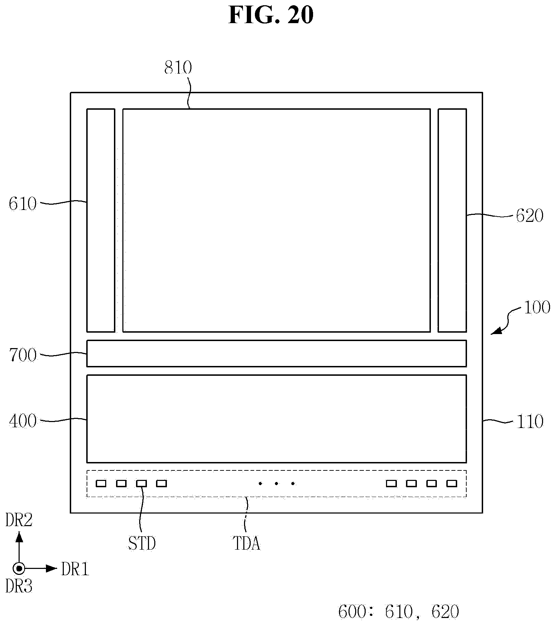

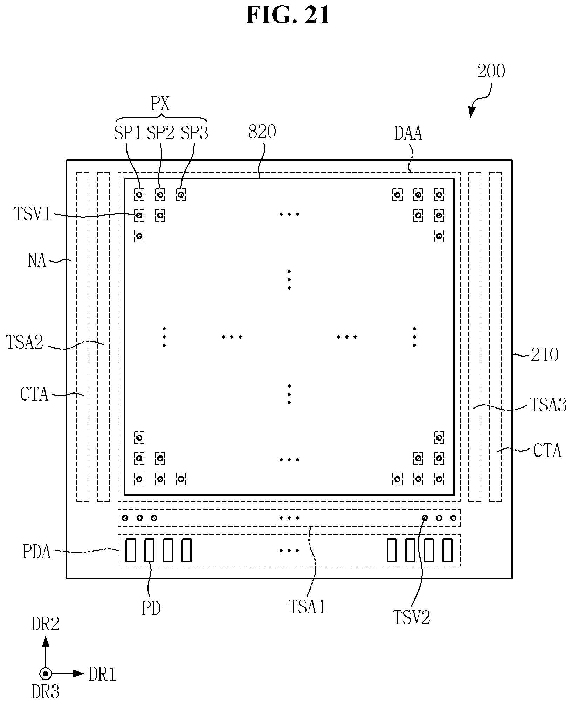

FIG. 20 is a plan view showing an example of a driving unit of a display device according to one or more embodiments. FIG. 21 is a plan view illustrating an example of a display unit of the display device of FIG. 20.

Referring to FIGS. 20 and 21, according to one or more embodiments, in the display device 10, the gate driver 600 may be disposed in the driving unit 100, and in the display unit 200, some of the plurality of signal lines GL (GCL and GBL) and the emission control lines EL1 and EL2 may be electrically connected to the gate driver 600 through through holes TSV3 and TSV4. The present embodiment is different from the embodiment of FIGS. 16 and 17 in that the disposition of the second scan driver and the emission driver and the connection with the pixel circuit PXC are different.

The driving unit 100 may include, as the gate driver 600, a scan driver 610 and an emission driver 620. The scan driver 610 is the same as the first scan driver 610 and the second scan driver 620 in the embodiment of FIGS. 16 and 17, and the emission driver 620 is the same as the emission driver 630 in the embodiment of FIGS. 16 and 17. The scan driver 610 and the emission driver 620 may be disposed on both sides of the first pixel circuit 810 in the first direction DR1, respectively.

However, as in the above-described embodiment, only the second transistor T2 from among the plurality of transistors constituting the pixel circuit PXC may be disposed in the driving unit 100, and the other transistors may be disposed in the display unit 200. Accordingly, the first scan line GWL and the data line DL may be disposed in the driving unit 100, and the second scan line GCL, the third scan line GBL, the emission control lines EL1 and EL2, and the driving voltage lines VSL, VDL, and VIL may be disposed in the display unit 200.

According to one or more embodiments, the display unit 200 may include the plurality of through hole areas TSA1, TSA2, and TSA3 formed in the non-display area NA. The first through hole area TSA1 may be disposed on the lower side of the display area DAA, which is one side in the second direction DR2. The second through hole area TSA2 may be disposed on the left side of the display area DAA, which is one side in the first direction DR1, and the third through hole area TSA3 may be disposed on the right side of the display area DAA, which is the other side in the first direction DR1. The second through hole area TSA2 and the third through hole area TSA3 may not overlap the driving unit 100.

The display unit 200 may include the plurality of first through holes TSV1 disposed in the display area DAA and the plurality of through holes TSV2, TSV3, and TSV4 disposed in the non-display area NA. The first through holes TSV1 may be disposed to respectively correspond to the plurality of sub-pixels SP1, SP2, and SP3 as described above. The first through holes TSV1 may electrically connect the transistors disposed on the different single crystal semiconductor substrates 110 and 210 from among the plurality of transistors constituting the pixel circuit PXC. For example, the second transistor T2 may be disposed on the first single crystal semiconductor substrate 110, and may be connected to other transistors through the first through hole TSV1 to constitute the pixel circuit PXC.

The plurality of second through holes TSV2 may be disposed in the first through hole area TSA1 in the non-display area NA. The second through holes TSV2 may be connection paths of signal connection lines that electrically connect the signal terminal STD of the driving unit 100 to the circuit board 300.

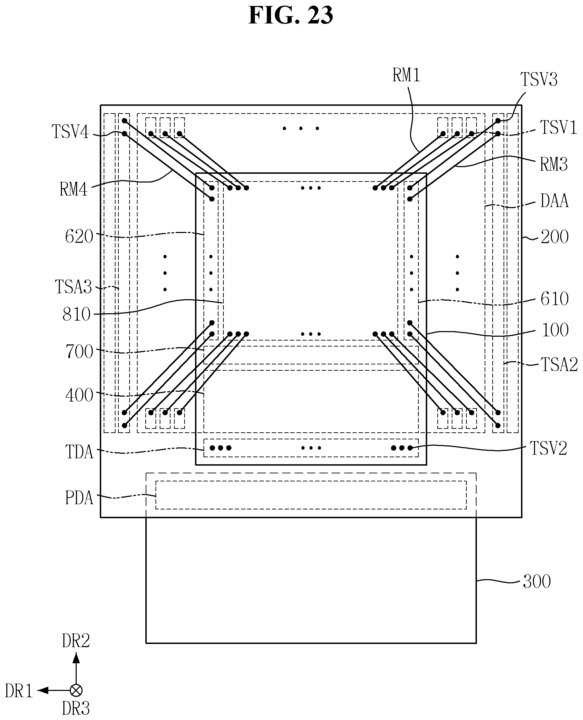

The plurality of third through holes TSV3 may be disposed in the second through hole area TSA2, and the fourth through holes TSV4 may be disposed in the third through hole area TSA3 (e.g., see FIG. 23). The third through holes TSV3 and the fourth through holes TSV4 may be respectively disposed in the non-display area NA and may not overlap the first single crystal semiconductor substrate 110 of the driving unit 100 (e.g., see FIG. 23). The third through holes TSV3 may be disposed to respectively correspond to the plurality of second scan lines GCL and third scan lines GBL disposed in the display area DAA, and the fourth through holes TSV4 may be disposed to respectively correspond to the plurality of emission control lines EL1 and EL2 disposed in the display area DAA. The number of third through holes TSV3 may be the same as the number of second scan lines GCL and third scan lines GBL, and the number of fourth through holes TSV4 may be the same as the number of emission control lines EL1 and EL2. For example, one pixel circuit PXC may be electrically connected to one second scan line GCL and one third scan line GBL. Accordingly, the number of third through holes TSV3 may be the same as twice the number of pixel rows of the plurality of sub-pixels SP1, SP2, and SP3 disposed in the display area DAA. Further, one pixel circuit PXC may be electrically connected to one first emission control line EL1 and one second emission control line EL2, and the number of fourth through holes TSV4 may be the same as twice the number of pixel rows of the plurality of sub-pixels SP1, SP2, and SP3 disposed in the display area DAA.

The plurality of second scan lines GCL and third scan lines GBL may be respectively electrically connected to connection lines disposed in the third through hole TSV3 and corresponding to the third through hole TSV3. The second scan line GCL and the third scan line GBL may be respectively connected to the scan driver 610 of the driving unit 100 through the connection lines disposed in the third through hole TSV3 (e.g., see FIG. 23). The plurality of first emission control lines EL1 and second emission control lines EL2 may be respectively electrically connected to connection lines disposed in the fourth through hole TSV4 and corresponding to the fourth through hole TSV4. The first emission control line EL1 and the second emission control line EL2 may be respectively connected to the emission driver 620 of the driving unit 100 through the connection lines disposed in the fourth through hole TSV4 (e.g., see FIG. 23).

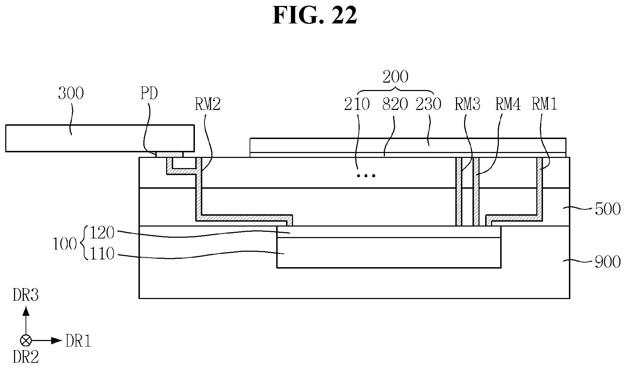

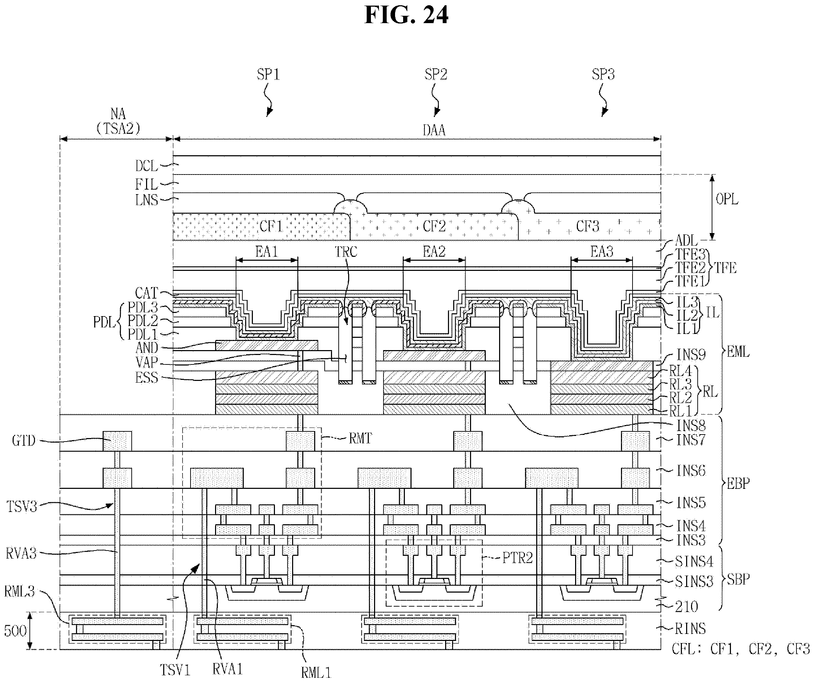

FIG. 22 is a schematic cross-sectional view of the display device of FIGS. 20 and 21. FIG. 23 is a schematic diagram showing a rear surface of the display device of FIGS. 20 and 21. FIG. 24 is a cross-sectional view showing a portion of the display unit of the display device of FIGS. 20 and 21.

Referring to FIGS. 22 - 24, the display device 10 may include the connection wiring layer 500 disposed between the second single crystal semiconductor substrate 210 of the display unit 200 and the driving circuit layer 120 of the driving unit 100. The connection wiring layer 500 may be disposed on the bottom surface of the second single crystal semiconductor substrate 210. The plurality of routing lines RM1, RM2, RM3, and RM4 may be partially disposed in the connection wiring layer 500, and the routing lines RM1, RM2, RM3, and RM4 may connect the second pixel circuit 820 of the display unit 200 and the circuit board 300 to the driving unit 100. The driving circuit layer 120 of the driving unit 100 may be electrically connected to the display unit 200 and the circuit board 300 through the routing lines RM1, RM2, RM3, and RM4 of the connection wiring layer 500 to transmit an electrical signal for light emission.

The first routing line RM1 may connect the pixel circuit PXC disposed in the display unit 200 and the first pixel circuit 810 of the driving unit 100. The first routing line RM1 may include the first conductive via RVA1 disposed in the first through hole TSV1, and the first connection line RML1 disposed in the connection wiring layer 500. The first routing line RM1 may be disposed in the display area DAA to connect the second transistor T2 of the pixel circuit PXC to other transistors. The description thereof may be the same as described above, and the description of the second routing line RM2 may also be the same as described above.

The third routing line RM3 may connect the second and third scan lines GCL and GBL disposed in the display unit 200 and the scan driver 610 disposed in the driving unit 100. The third routing line RM3 may include a third conductive via RVA3 disposed in the third through hole TSV3 formed in the second single crystal semiconductor substrate 210 and a third connection line RML3 disposed in the connection wiring layer 500. The third conductive via RVA3 may be connected to the terminal GTD of the display unit 200, and the terminal GTD may be connected to any one of the second and third scan lines GCL and GBL. The plurality of third through holes TSV3 may be disposed in the second through hole area TSA2 in the non-display area NA of the display unit 200, and may not overlap the driving unit 100 in the thickness direction (e.g., the third direction DR3). The third routing line RM3 may connect the scan driver 610 and the third through hole TSV3 that does not overlap the driving unit 100. The third routing line RM3, or the third connection line RML3 may partially overlap the driving unit 100.

The fourth routing line RM4 may connect the first and second emission control lines EL1 and EL2 disposed in the display unit 200 and the emission driver 620 disposed in the driving unit 100. The fourth routing line RM4 may include a fourth conductive via disposed in the fourth through hole TSV4 formed in the second single crystal semiconductor substrate 210 and a fourth connection line disposed in the connection wiring layer 500. The plurality of fourth through holes TSV4 may be disposed in the third through hole area TSA3 in the non-display area NA of the display unit 200, and may not overlap the driving unit 100 in the thickness direction (e.g., the third direction DR3). The fourth routing line RM4 may connect the emission driver 620 and the fourth through hole TSV4 that does not overlap the driving unit 100. The fourth routing line RM4, or the fourth connection line may partially overlap the driving unit 100.

The plurality of second scan lines GCL and third scan lines GBL may extend in the first direction DR1, and may be respectively connected to the third through hole TSV3 in parallel without being bent even in the non-display area NA. The plurality of first emission control lines EL1 and second emission control lines EL2 may also extend in the first direction DR1, and may be respectively connected to the fourth through hole TSV4 in parallel without being bent even in the non-display area NA. The display device 10 may maintain a constant gap of the signal lines in the display area DAA and the non-display area NA of the display unit 200, and may omit a fan-out structure in which the signal lines bend and narrow in width in the non-display area NA. The gap between the third through holes TSV3 and the gap between the fourth through holes TSV4 may also be constant, similarly to the signal lines. However, the routing lines disposed on the rear surface of the display unit 200, such as the connection lines RML3 of the third routing line RM3 and the connection lines of the fourth routing line RM4, connect the edge of the display unit 200 and the driving unit 100 having a small area, so that the gap may become narrower toward the driving unit 100. Also in the case of the first routing line RM1, the pixel circuits PXC disposed in the display area DAA having a large area and the driving unit 100 having a small area are connected, so that the gap may become narrower toward the driving unit 100.

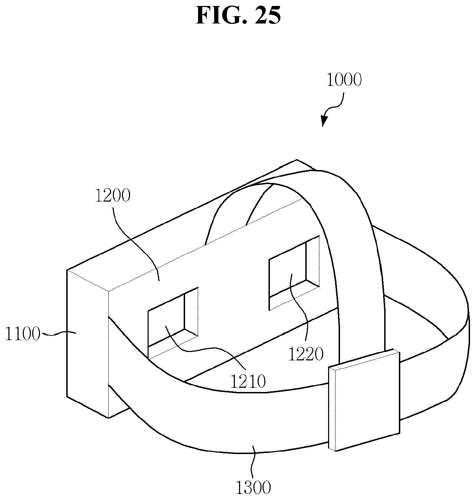

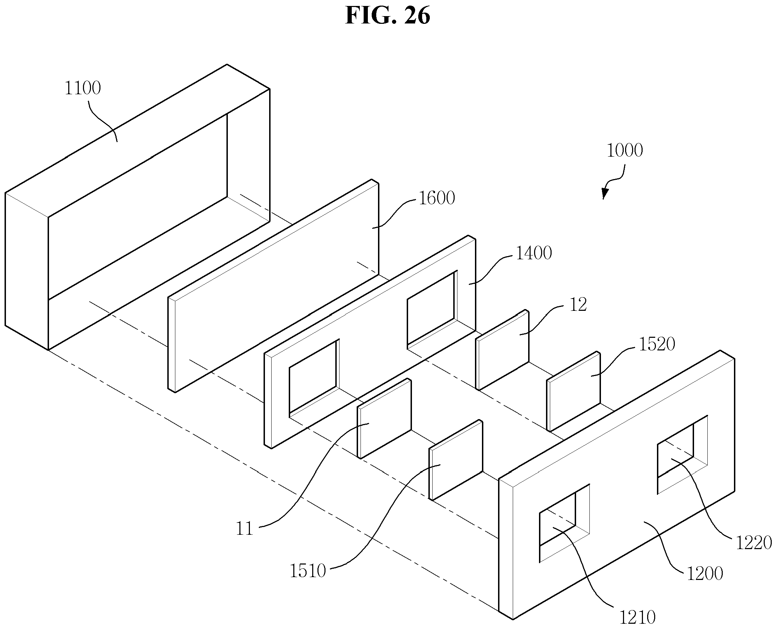

FIG. 25 is a perspective view illustrating a head mounted display device according to one or more embodiments. FIG. 26 is an exploded perspective view showing an example of the head mounted display device of FIG. 25.

Referring to FIGS. 25 and 26, a head mounted display device 1000 according to one or more embodiments includes a first display device 11, a second display device 12, a display device housing 1100, a housing cover 1200, a first eyepiece 1210, a second eyepiece 1220, a head mounted band 1300, a middle frame 1400, a first optical member 1510, a second optical member 1520, a control circuit board 1600, and a connector.

The first display device 11 provides an image to a user's left eye, and the second display device 12 provides an image to a user's right eye. Because each of the first display device 11 and the second display device 12 is substantially the same as the display device 10 described in conjunction with FIG. 1, the description of the first display device 11 and the second display device 12 will be omitted.

The first optical member 1510 may be disposed between the first display device 11 and the first eyepiece 1210. The second optical member 1520 may be disposed between the second display device 12 and the second eyepiece 1220. Each of the first optical member 1510 and the second optical member 1520 may include at least one convex lens.

The middle frame 1400 may be disposed between the first display device 11 and the control circuit board 1600 and between the second display device 12 and the control circuit board 1600. The middle frame 1400 serves to support and fix the first display device 11, the second display device 12, and the control circuit board 1600.

The control circuit board 1600 may be disposed between the middle frame 1400 and the display device housing 1100. The control circuit board 1600 may be connected to the first display device 11 and the second display device 12 through the connector. The control circuit board 1600 may convert an image source inputted from the outside into the digital video data DATA, and may transmit the digital video data DATA to the first display device 11 and the second display device 12 through the connector.

The control circuit board 1600 may transmit the digital video data DATA corresponding to a left-eye image optimized for the user's left eye to the first display device 11, and may transmit the digital video data DATA corresponding to a right-eye image optimized for the user's right eye to the second display device 12. Alternatively, the control circuit board 1600 may transmit the same digital video data DATA to the first display device 11 and the second display device 12.

The display device housing 1100 serves to accommodate the first display device 11, the second display device 12, the middle frame 1400, the first optical member 1510, the second optical member 1520, the control circuit board 1600, and the connector. The housing cover 1200 is disposed to cover one open surface of the display device housing 1100. The housing cover 1200 may include the first eyepiece 1210 at which the user's left eye is disposed and the second eyepiece 1220 at which the user's right eye is disposed. It is illustrated in the drawing that the first eyepiece 1210 and the second eyepiece 1220 are disposed separately, but the present disclosure is not limited thereto. The first eyepiece 1210 and the second eyepiece 1220 may be combined into one.

The first eyepiece 1210 may be aligned with the first display device 11 and the first optical member 1510, and the second eyepiece 1220 may be aligned with the second display device 12 and the second optical member 1520. Accordingly, the user may view the image of the first display device 11 magnified as a virtual image by the first optical member 1510 through the first eyepiece 1210, and may view the image of the second display device 12 magnified as a virtual image by the second optical member 1520 through the second eyepiece 1220.

The head mounted band 1300 serves to secure the display device housing 1100 to the user's head such that the first eyepiece 1210 and the second eyepiece 1220 of the housing cover 1200 remain disposed on the user's left and right eyes, respectively. When the display device housing 1200 is implemented to be lightweight and compact, the head mounted display device 1000 may be provided with an eyeglass frame instead of the head mounted band 1300.

In addition, the head mounted display device 1000 may further include a battery for supplying power, an external memory slot for accommodating an external memory, and an external connection port and wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, and/or a Bluetooth module.

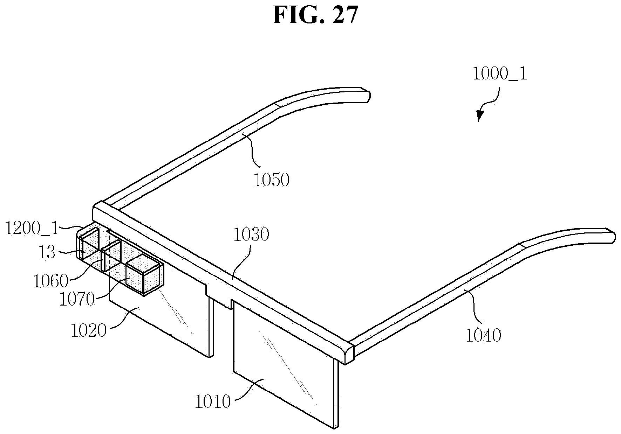

FIG. 27 is a perspective view illustrating a head mounted display device according to one or more embodiments.

Referring to FIG. 27, a head mounted display device 1000_1 according to one or more embodiments may be an eyeglasses-type display device in which a display device housing 1200_1 is implemented in a lightweight and compact manner. The head mounted display device 1000_1 according to one or more embodiments may include a display device 13, a left eye lens 1010, a right eye lens 1020, a support frame 1030, temples 1040 and 1050, an optical member 1060, an optical path changing member 1070, and the display device housing 1200_1.

The display device housing 1200_1 may include the display device 13, the optical member 1060, and the optical path changing member 1070. An image displayed on the display device 13 may be magnified by the optical member 1060, and the optical path may be changed by the optical path changing member 1070 to provide the image to the user's right eye through the right eye lens 1020. As a result, the user may view an augmented reality image, through the right eye, in which a virtual image displayed on the display device 13 and a real image seen through the right eye lens 1020 are combined.

It is illustrated in the drawing that the display device housing 1200_1 is disposed at the right end of the support frame 1030, but the present disclosure is not limited thereto. For example, the display device housing 1200_1 may be disposed on the left end of the support frame 1030, and in this case, the image of the display device 13 may be provided to the user's left eye. Alternatively, the display device housing 1200_1 may be disposed on both the left and right ends of the support frame 1030, and in this case, the user may view the image displayed on the display device 13 through both the left and right eyes.

It should be understood, however, that the aspects and features of embodiments of the present disclosure are not restricted to the one set forth herein. The above and other aspects of the present disclosure will become more apparent to one of ordinary skill in the art to which the present disclosure pertains by referencing the claims, with equivalents thereof to be included therein.

## Claims

1. A display device comprising:
a first single crystal semiconductor substrate on which a plurality of first transistors is formed;
a second single crystal semiconductor substrate on the first single crystal semiconductor substrate, and on which a plurality of second transistors is formed; and
a connection wiring layer between the first single crystal semiconductor substrate and the second single crystal semiconductor substrate,
wherein the second single crystal semiconductor substrate comprises a display area where a plurality of light emitting elements electrically connected to the plurality of second transistors is located, and a non-display area around the display area, and
wherein a plurality of first through holes is located in the display area of the second single crystal semiconductor substrate and in which a first conductive via connected to each of the plurality of first transistors and the plurality of second transistors is located.

2. The display device of claim 1, further comprising a first driving voltage line in a common electrode contact area of the non-display area on at least one side of the display area, and a second driving voltage line in the display area,
wherein a second transistor from among the plurality of second transistors is connected to the second driving voltage line, and
wherein a light emitting element from among the plurality of light emitting elements is connected to the first driving voltage line.

3. The display device of claim 1 or claim 2, wherein an area of the first single crystal semiconductor substrate in a plan view is smaller than an area of the second single crystal semiconductor substrate in a plan view.

4. The display device of claim 3, wherein the connection wiring layer comprises a plurality of first connection lines connected to the first conductive via, and
wherein at least a portion of the plurality of first connection lines does not overlap the first single crystal semiconductor substrate.

5. The display device of any preceding claim, wherein the second single crystal semiconductor substrate comprises a pad area on one side of the display area, and a plurality of second through holes between the pad area and the display area.

6. The display device of any preceding claim, further comprising a first scan driver and a data driver on the first single crystal semiconductor substrate and comprising the plurality of first transistors; optionally:
wherein the display device further comprises:
first scan lines on the first single crystal semiconductor substrate and connected to a first transistor from among the plurality of first transistors and the first scan driver; and
data lines on the first single crystal semiconductor substrate and connected to the first transistor and the data driver.

7. The display device of any preceding claim, wherein the second single crystal semiconductor substrate comprises a plurality of second scan lines and a plurality of emission control lines electrically connected to some of the plurality of second transistors; optionally:
wherein the second single crystal semiconductor substrate comprises a second scan driver in the non-display area and connected to the plurality of second scan lines, and an emission driver in the non-display area and connected to an emission control line from among the plurality of emission control lines.

8. The display device of claim 7, wherein the second single crystal semiconductor substrate comprises a plurality of third through holes in which a conductive via connected to a second scan line from among the plurality of second scan lines is located, and a plurality of fourth through holes in which a conductive via connected to an emission control line from among the plurality of emission control lines is located, and
wherein the first single crystal semiconductor substrate comprises a second scan driver connected to the second scan line through the conductive via in the third through hole, and an emission driver connected to the emission control line through the conductive via in the fourth through hole.

9. The display device of claim 8, wherein:
(i) each of the plurality of third through holes and the plurality of fourth through holes does not overlap the first single crystal semiconductor substrate; and/or
(ii) a number of the plurality of third through holes is the same as a number of the plurality of fourth through holes; and/or
(iii) the connection wiring layer comprises connection lines connected to a plurality of conductive vias in the plurality of third through holes and the plurality of fourth through holes, and
wherein each of the connection lines has a portion that does not overlap the first single crystal semiconductor substrate.

10. The display device of any preceding claim, wherein a number of the first through holes is equal to a number of the light emitting elements in the display area.

11. The display device of any preceding claim, wherein a minimum line width of a first transistor from among the plurality of first transistors is smaller than a minimum line width of a second transistor from among the plurality of second transistors.

12. A display device comprising:
a first single crystal semiconductor substrate on which a plurality of first transistors is formed and a plurality of first scan lines and a plurality of data lines are located;
a second single crystal semiconductor substrate on the first single crystal semiconductor substrate, on which a plurality of second transistors is formed, and at least one driving voltage line connected to some of the plurality of second transistors is located;
a display element layer on the second single crystal semiconductor substrate, and comprising a plurality of light emitting elements; and
a connection wiring layer located between the display element layer and the first single crystal semiconductor substrate,
wherein the plurality of light emitting elements is electrically connected to the at least one driving voltage line, the plurality of first transistors, and the plurality of second transistors,
wherein the connection wiring layer comprises a first connection line connected to a first conductive via in a first through hole penetrating the second single crystal semiconductor substrate, and
wherein the first conductive via is electrically connected to the plurality of first transistors and the plurality of second transistors.

13. The display device of claim 12, wherein the at least one driving voltage line comprises a first driving voltage line connected to one electrode of a light emitting element from among the plurality of light emitting elements, and a second driving voltage line electrically connected to a second transistor from among the plurality of second transistors.

14. The display device of claim 12 or claim 13, further comprising a plurality of second scan lines and a plurality of emission control lines on the second single crystal semiconductor substrate; and/or
wherein an area of the first single crystal semiconductor substrate in a plan view is smaller than an area of the second single crystal semiconductor substrate in a plan view.

15. A head mounted display device comprising:
a frame mounted on a user's body and corresponding to left and right eyes;
a plurality of display devices in the frame; and
a lens on each of the plurality of display devices,
wherein the display device comprises:
a first single crystal semiconductor substrate on which a plurality of first transistors is formed;
a second single crystal semiconductor substrate on the first single crystal semiconductor substrate, and on which a plurality of second transistors is formed; and
a connection wiring layer between the first single crystal semiconductor substrate and the second single crystal semiconductor substrate,
wherein the second single crystal semiconductor substrate comprises a display area where a plurality of light emitting elements electrically connected to the second transistors is located, and a non-display area around the display area, and
wherein a plurality of first through holes in the display area of the second single crystal semiconductor substrate and in which a first conductive via connected to each of the plurality of first transistors and the plurality of second transistors is located.
